(19) Europäisches Patentamt / European Patent Office / Office européen des brevets

(11) **EP 3 798 625 A1**

(12) **EUROPEAN PATENT APPLICATION**
published in accordance with Art. 153(4) EPC

(43) Date of publication:
**31.03.2021 Bulletin 2021/13**

(51) Int Cl.:
*G01N 24/00* (2006.01)    *H01F 6/04* (2006.01)

(21) Application number: **19807476.7**

(22) Date of filing: **23.05.2019**

(86) International application number:
**PCT/JP2019/020564**

(87) International publication number:
**WO 2019/225721 (28.11.2019 Gazette 2019/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.05.2018  JP 2018098955**

(71) Applicant: **NIPPON STEEL CORPORATION**
**Chiyoda-ku**
**Tokyo 100-8071 (JP)**

(72) Inventor: **MORITA, Mitsuru**
**Tokyo 100-8071 (JP)**

(74) Representative: **Vossius & Partner**
**Patentanwälte Rechtsanwälte mbB**
**Siebertstrasse 3**
**81675 München (DE)**

(54) **MAGNETIC-FIELD-GENERATING APPARATUS AND METHOD FOR MAGNETIZING MAGNETIC-FIELD-GENERATING APPARATUS**

(57) The present invention is a magnetic-field generating device including a magnet unit that generates a magnetic field in a bore space, the magnet unit includes an inner tank, a first intermediate tank, and a second intermediate tank, and the magnet unit includes an oxide superconducting bulk, a first cold insulation layer that is arranged around the oxide superconducting bulk inside the inner tank, and is configured to be capable of storing nitrogen at least in a liquid, gas, or solid state as a refrigerant, and capable of being depressurized to a first pressure of lower than 1 atm, a second cold insulation layer that is arranged between the first intermediate tank and the second intermediate tank and is configured to be capable of storing liquid nitrogen as a refrigerant, a first supply unit configured to be capable of supplying liquid nitrogen to the first cold insulation layer, a second supply unit configured to be capable of supplying liquid nitrogen to the second cold insulation layer, and a first pressure reducing unit configured to be capable of depressurizing the first cold insulation layer.

FIG. 2

## Description

[Technical Field of the Invention]

The present invention relates to a magnetic-field generating device and a method for magnetizing the magnetic-field generating device.

Priority is claimed on Japanese Patent Application No. 2018-098955, filed May 23, 2018, the content of which is incorporated herein by reference.

[Related Art]

Conventional nuclear magnetic resonance (NMR) devices (hereinafter, also referred to as "NMR devices") mainly use, as a magnetic field generation source, a superconducting magnet having a coil made by using a metal-based superconductor such as NbTi or $Nb_3Sn$ as a wire rod, for example. This superconducting magnet is capable of generating a magnetic field that is a strong magnetic field exceeding 10 T and has extremely high magnetic field homogeneity. The critical temperature at which the superconductivity of the metal-based superconductor appears is, for example, 10 K for NbTi and 18 K for $Nb_3Sn$. In order to generate the magnetic field that is a strong magnetic field and has high magnetic field homogeneity, these metal-based superconductors are cooled mainly by liquid helium and kept at about 4.2 K.

Helium used for cooling the metal-based superconductor is a rare resource and thus is expensive, and is a substance whose supply may be short. For this reason, in conventional NMR devices using a metal-based superconductor, in order to improve the use efficiency of helium by suppressing the amount of evaporation of liquid helium, a layer storing liquid nitrogen is provided around a liquid helium layer, and thus heat penetration from the external space at room temperature into the liquid helium layer is suppressed. In addition, in order to improve the use efficiency of helium, a technique of suppressing emission of helium to the external space has been proposed. For example, Non-Patent Document 1 discloses a superconducting magnet that is composed of a metal-based superconductor and used in a state of being immersed in liquid helium.

Examples of a material with superconductivity include oxide-based superconductors, in addition to the metal-based superconductors described above. The critical temperature of these oxide-based superconductors is about 90 K, which is higher than that of the metal-based superconductors. The oxide superconducting bulk that is a bulk of the oxide-based superconductor can thus be made to undergo a transition from a normal conducting state to a superconducting state without using a special refrigerant such as liquid helium.

Consequently, in recent years, there has been proposed a relatively small magnet for an NMR device that uses an oxide superconducting bulk undergoing a transition to a superconducting state when cooled with liquid nitrogen or the like. For example, Patent Document 1 proposes a nuclear magnetic resonance device that cools an oxide superconducting bulk by a refrigerating machine. Patent Document 2 describes a superconducting magnet device in which the first refrigerant is liquid nitrogen and the second refrigerant is liquid helium. Patent Document 3 describes a cooling method and a cooling device that cool a superconducting material in which $RE_2BaCuO_5$ of several $\mu$m in size is finely dispersed in single crystalline $REBa_2Cu_3O_{7-x}$ by depressurizing liquid nitrogen. Patent Document 4 describes a cryogenic storage container in which a solid refrigerant is prepared by cold heat generated using a refrigerating machine, and heat entering a solid refrigerant layer is reduced by using a liquid refrigerant formed by melting the solid refrigerant.

[Citation List]

[Patent Document]

[Patent Document 1]
Japanese Unexamined Patent Application, First Publication No. 2002-6021
[Patent Document 2]
Japanese Unexamined Utility Model Application, First Publication No. S 63-165812
[Patent Document 3]
PCT International Publication No. WO 92/22077
[Patent Document 4]
Japanese Patent (Granted) Publication No. 5086920

[Summary of Invention]

[Problems to be Solved by the Invention]

Superconducting coils using a wire rod made of a metallic superconducting material having a low critical temperature need to be cooled at a level of 4.2 K by liquid helium or a cryogenic refrigerating machine. On the other hand, oxide superconducting materials having a critical temperature of about 90 K eliminate the need of cooling at a level of 4.2 K by the refrigerating machine or liquid helium, maintain their superconducting state even in a high-temperature environment of 90 K or lower, and can be cooled by liquid nitrogen that is inexpensive and whose supply is stable. Examples of a material for an NMR magnet that requires a magnetic field that is a strong magnetic field of several T and has homogeneity include an oxide superconducting bulk that has a structure in which single crystalline $REBa_2Cu_3O_y$ (RE is one, or two or more elements selected from rare earth elements, and $6.8 \leq y \leq 7.1$) is dispersed.

However, since only a relatively low current density is obtained by liquid nitrogen (77 K) at atmospheric pressure, it is necessary to cool the NMR magnet to a low-temperature region below 77 K where a higher critical current density can be obtained. Requirements for cooling the NMR magnet include keeping stably a constant temperature for a long period of time.

Patent Document 2 describes a superconducting magnet device (MRI) in which the first refrigerant is liquid nitrogen and the second refrigerant is liquid helium, and the superconducting magnet device has a structure in which a liquid nitrogen tank is disposed outside a liquid helium tank so as to basically block heat radiation from the external space at room temperature. However, heat radiation from liquid nitrogen (77 K) is received by liquid helium (4.2 K), which causes heat penetration and consumes helium.

The amount of heat (P) transferred from a surrounding substance B of Tb (K) to an object A of Ta (K) due to heat radiation is proportional to the difference between the fourth powers of absolute temperatures. That is,

$$P \propto (Tb)^4 - (Ta)^4.$$

As described above, the amount of heat penetration in the case of liquid nitrogen at reduced pressure and liquid nitrogen at atmospheric pressure can be made about half the amount of heat penetration in the case of liquid helium and liquid nitrogen at atmospheric pressure. Further, since the heat of vaporization of liquid nitrogen is much larger than the heat of vaporization of liquid helium, it can be said that the method for cooling an oxide superconducting bulk magnet by a combination of liquid nitrogen at reduced pressure and liquid nitrogen at atmospheric pressure is basically a very excellent method for cooling an NMR magnet. In such a situation, it is very important to suppress heat penetration from pipes, outer walls, or the like in holding and supplying a refrigerant for the purpose of stably keeping a temperature for a long period of time, and a method for supplying a refrigerant and a structure for keeping a device cool and insulating the device are important issues. Specifically, the issue is how to utilize liquid nitrogen stored in the outer peripheral portion for the purpose of easily and continuously keeping the temperature of a superconductor stably for a long period of time.

As described in Patent Document 3, liquid nitrogen can be cooled to about 63 K by being depressurized relatively inexpensively and easily by a rotary pump or the like. However, the NMR magnet needs to form a uniform and strong magnetic field space in its internal space at room temperature, and also needs to be continuously kept stably at a constant temperature for a long period of time. Consequently, it is necessary to suppress heat penetration from the outside to the portion filled with liquid nitrogen of less than 77 K in which the oxide superconducting bulk magnet is housed. The structure described in Patent Document 3 supposedly requires a tank for liquid nitrogen at atmospheric pressure that surrounds a tank for liquid nitrogen at reduced pressure for stably keeping the NMR magnet at a constant temperature for a long period of time, but such a structure is not described. The NMR magnet cannot function properly in the structure described in Patent Document 3.

The present invention has been made in view of the above problems, and an object of the present invention is to provide a magnetic-field generating device and a method for magnetizing the magnetic-field generating device that can achieve a magnetic field with high homogeneity stably and continuously for a long period of time without using liquid helium or a cooling device.

[Means for Solving the Problem]

The outline of the present invention is as follows.

    (1) A first aspect of the present invention is a magnetic-field generating device including a magnet unit that generates a magnetic field in a bore space, wherein the magnet unit includes an inner tank having a hollow ring shape, a first intermediate tank that is arranged so as to include the inner tank, and a second intermediate tank that is arranged so as to include the first intermediate tank, and the magnet unit includes an oxide superconducting bulk that is a ring shape arranged inside the inner tank and has a structure in which single crystalline $ReBa_2Cu_3O_y$ (RE is one, or two or more elements selected from rare earth elements, and $6.8 \leq y \leq 7.1$) is dispersed, a first cold insulation layer that is arranged around the oxide superconducting bulk inside the inner tank, and is configured to be capable of storing nitrogen at least in a liquid, gas, or solid state as a refrigerant, and capable of being depressurized to a first pressure of lower than 1 atm, a second cold insulation layer that is arranged between the first intermediate tank and the second intermediate tank and is configured to be capable of storing liquid nitrogen as a refrigerant, a first supply unit configured to be capable of supplying liquid nitrogen to the first cold insulation layer, a second supply unit configured to be capable of supplying liquid nitrogen to the second cold insulation layer, and a first pressure reducing unit configured to be capable of depressurizing the first cold insulation layer.

(2) In the magnetic-field generating device of (1), the first supply unit may be configured to allow the second cold insulation layer to communicate with the first cold insulation layer.

(3) The magnetic-field generating device of (2) may further include a control unit that controls the magnet unit, a first nitrogen amount sensor that detects an amount of liquid nitrogen in the first cold insulation layer, and a second nitrogen amount sensor that detects an amount of liquid nitrogen in the second cold insulation layer, wherein the control unit may control the first supply unit and the second supply unit based on the amount of liquid nitrogen in the first cold insulation layer and the amount of liquid nitrogen in the second cold insulation layer.

(4) In the magnetic-field generating device of any one of (1) to (3), the first supply unit may further include a precooling chamber having a third pressure reducing unit configured to be capable of supplying depressurized liquid nitrogen.

(5) The magnetic-field generating device of (4) further includes a control unit that controls the magnet unit, wherein the precooling chamber may further include a third supply unit configured to be capable of supplying liquid nitrogen to the precooling chamber and a third nitrogen amount sensor that detects an amount of liquid nitrogen in the precooling chamber, and the control unit may control the first supply unit and the third supply unit so as to allow the amount of liquid nitrogen in the precooling chamber to fall within a predetermined range.

(6) The magnetic-field generating device of (4) or (5) may further include a control unit that controls the magnet unit and a third temperature sensor that detects a temperature of the precooling chamber, wherein the control unit may control at least any one of the first supply unit, the third supply unit, or the third pressure reducing unit so as to keep the temperature of the precooling chamber in a predetermined preset temperature range.

(7) The magnetic-field generating device of any one of (1) to (6) may further include a second pressure reducing unit that is capable of depressurizing the second cold insulation layer to a second pressure that is lower than 1 atm and equal to or higher than a first pressure.

(8) The magnetic-field generating device of any one of (1) to (7) may further include a control unit that controls the magnet unit and a first temperature sensor that detects a temperature of the first cold insulation layer, wherein the control unit may control at least any one of the first supply unit or the first pressure reducing unit so as to keep the temperature of the first cold insulation layer in a predetermined preset temperature range.

(9) A second aspect of the present invention is a method for magnetizing the magnetic-field generating device of any one of (1) to (8), the method including a first step of supplying liquid nitrogen to the second cold insulation layer and a second step of supplying liquid nitrogen to the first cold insulation layer after the first step.

(10) The method for magnetizing a magnetic-field generating device of (9), wherein the method may further include, before the first step, a third step of arranging the magnet unit in a hollow space of a magnetizing unit having a hollow ring shape and a fourth step of exciting the magnetizing unit to generate an external magnetic field, and the method may further include, after the second step, a fifth step of depressurizing the first cold insulation layer to the first pressure and a sixth step of demagnetizing the magnetizing unit to remove the external magnetic field.

(11) The method for magnetizing a magnetic-field generating device of (10) may further include a seventh step of depressurizing the first cold insulation layer to a third pressure lower than the first pressure after the sixth step.

[Effects of the Invention]

According to the present invention, it is possible to provide a magnetic-field generating device and a method for magnetizing the magnetic-field generating device that can obtain a magnetic field with higher homogeneity by keeping the temperature of a bulk magnet stably and continuously for a long time without using liquid helium or a cooling device.

[Brief Description of the Drawings]

Fig. 1 is a block diagram illustrating a magnetization system to which a magnetic-field generating device for NMR according to a first embodiment of the present invention can be applied.

Fig. 2 is a schematic view for explaining the magnetic-field generating device for NMR according to the first embodiment.

Fig. 3 is a schematic view illustrating another aspect of the magnetic-field generating device for NMR according to the first embodiment.

Fig. 4 is a schematic view for explaining a method for magnetizing the magnetic-field generating device for NMR according to the first embodiment.

Fig. 5 is a flowchart for explaining an operation of the magnetic-field generating device for NMR according to the first embodiment when magnetized.

Fig. 6 is a flowchart for explaining an operation of the magnetic-field generating device for NMR according to the first embodiment at the time of supplying liquid nitrogen.

Fig. 7 is a schematic view illustrating a modification of the magnetic-field generating device for NMR according to the first embodiment.

Fig. 8 is a schematic view illustrating a magnetic-field generating device for NMR according to a second embodiment of the present invention.

Fig. 9 is a flowchart for explaining an operation of the magnetic-field generating device for NMR according to the second embodiment when magnetized.

Fig. 10 is a flowchart for explaining an operation of the magnetic-field generating device for NMR according to the second embodiment at the time of supplying liquid nitrogen.

Fig. 11 is a schematic view illustrating a magnetic-field generating device for NMR according to a third embodiment of the present invention.

Fig. 12 is a flowchart for explaining an operation of the magnetic-field generating device for NMR according to the third embodiment when magnetized.

Fig. 13 is a flowchart for explaining an operation of the magnetic-field generating device for NMR according to the third embodiment at the time of supplying liquid nitrogen.

Fig. 14 is a schematic view illustrating a magnetic-field generating device for NMR according to a fourth embodiment of the present invention.

Fig. 15 is a flowchart for explaining an operation of the magnetic-field generating device for NMR according to the fourth embodiment when magnetized.

Fig. 16 is a flowchart for explaining an operation of the magnetic-field generating device for NMR according to the fourth embodiment at the time of supplying liquid nitrogen.

Fig. 17 is a schematic view illustrating a modification of a magnet unit according to the present invention.

[Embodiments of the Invention]

Preferred embodiments of the present invention will be described below in detail with reference to the accompanying drawings, using a magnetic-field generating device for NMR as an example. In the present specification and the drawings, constituent elements having substantially the same functional configuration are designated by the same reference numerals, and duplicate description is omitted.

In addition, in the present specification and the drawings, a plurality of constituent elements having substantially the same functional configuration may be distinguished by attaching different alphabets after the same reference numeral. However, when it is not necessary to particularly distinguish each of a plurality of constituent elements having substantially the same functional configuration, only the same reference numeral is given.

<1. First Embodiment

[1-1. Description of NMR Device]

First, an NMR device in which a magnetic-field generating device for NMR according to a first embodiment of the present invention can be used will be described. An NMR device is an analyzer in which a sample placed in a magnetic field is irradiated with radio waves to cause nuclear spins of atomic nuclei in the sample to resonate, and the energy absorbed at resonance is detected as an NMR signal, thereby obtaining information such as the molecular structure or physical and chemical properties of the sample.

The NMR device is basically configured to include a magnetic field generator, a high-frequency generator that generates electromagnetic waves, a probe that irradiates a sample with electromagnetic waves to detect NMR signals, an electromagnetic wave oscillator, an amplifier and a spectrometer for NMR signals, and a computer that performs data processing.

Here, an operation of the NMR device will be briefly described. In the NMR device, a magnetic field generator having a superconducting magnet forms a strong magnetic field with high homogeneity in a sample space. The sample, which is a measurement target, is placed in such a magnetic field space. The sample is irradiated with radio waves generated by the high-frequency generator from the probe. The probe detects the energy of radio waves absorbed during the nuclear magnetic resonance of atomic nuclei in the sample as an NMR signal. The computer calculates an NMR spectrum based on the NMR signal received from the probe. The molecular structure of the sample or the like is analyzed from the NMR spectrum obtained.

The homogeneity of the magnetic field intensity generated by the magnet of the NMR device requires that the ratio of the difference between the maximum magnetic field intensity and the minimum magnetic field intensity to an average magnetic field intensity is in the order of ppm or less in a region where the magnetic field distribution desirably has homogeneity.

[1-2. Composition of Oxide Superconducting Bulk]

First, an oxide superconducting bulk used in the embodiments of the present invention will be described. The oxide superconducting bulk used in the embodiments has a structure in which a non-superconducting phase represented by $RE_2BaCuO_5$ (211 phase) or the like is finely dispersed in single crystalline $REBa_2Cu_3O_y$ (123 phase). Here, the term "single crystalline" not only refers to only a perfect single crystal, but also includes a single crystal having a defect that does not impair practical use such as a low-angle grain boundary. RE, which is one of the elements constituting the 123 phase and the 211 phase, includes one or more elements selected from the group consisting of La, Nd, Sm, Eu, Gd, Dy, Ho, Er, Tm, Yb, Lu, and Y. However, in some cases, the 123 phase containing any of La, Nd, Sm, Eu, or Gd deviates from the stoichiometric composition of 1 : 2 : 3, and a part of RE at the position where RE is arranged (RE site) is substituted by Ba. It is known in the 211 phase, which is a non-superconducting phase, that, for La and Nd, the ratio of the metallic elements constituting the 211 phase sometimes has a non-stoichiometric composition unlike Y, Sm, Eu, Gd, Dy, Ho, Er, Tm, Yb, and Lu, and the crystal structure of the 211 phase is sometimes different from those of the elements.

The substitution of RE by Ba, which has been described above, tends to reduce the critical temperature of the oxide superconducting bulk. Further, when the oxide superconducting bulk is produced in an environment with a lower oxygen partial pressure, the substitution of RE by Ba tends to be suppressed.

Such a single crystalline oxide superconducting bulk is produced not by a sintering method, which is a common method for producing ceramics, but by a melt crystal growth method in which a molded body is heated to a melting temperature or higher, which is higher than a sintering temperature to be in a semi-molten state, and then undergoes crystal growth during slow cooling, as described below in detail.

The 123 phase is generated by the peritectic reaction of the 211 phase and a liquid phase composed of a complex oxide of Ba and Cu as indicated below.

211 phase + liquid phase (complex oxide of Ba and Cu) $\rightarrow$ 123 phase

The temperature at which the 123 phase is generated by this peritectic reaction (Tf: temperature at which 123 phase is generated) is related to the ionic radius of the RE element, and $T_f$ decreases as RE having a smaller ionic radius is contained. In addition, $T_f$ decreases as the oxygen partial pressure during the peritectic reaction decreases. When Ag is further contained as the element constituting the 123 phase and the 211 phase, $T_f$ tends to decrease.

The structure in which the 211 phase is finely dispersed in the single crystalline 123 phase is formed because unreacted 211 grains remain in the 123 phase during the crystal growth of the 123 phase. That is, the bulk described above is formed by the following reaction.

211 phase + liquid phase (complex oxide of Ba and Cu) $\rightarrow$ 123 phase + 211 phase

Fine dispersion of the 211 phase in the oxide superconducting bulk is very important in view of improving a critical current density (Jc). As a small amount at least of any one of Pt, Rh, or Ce is contained in addition to the constituent elements described above, the grain growth of the 211 phase in a semi-molten state (state constituted by 211 phase and liquid phase) is suppressed. As a result, the grain size of the 211 phase in the oxide superconducting bulk is reduced to about 1 $\mu$m. The amount of elements at least any one of Pt, Rh, or Ce is preferably added in an amount that allows a refinement effect to appear. In view of material costs, the amounts of these elements added are preferably, for example, Pt: 0.2 to 2.0 mass%, Rh: 0.01 to 0.5 mass%, and Ce: 0.5 to 2.0 mass%. The added Pt, Rh, and Ce partially form a solid solution in the 123 phase. Further, the remaining portion of the added Pt, Rh, and Ce that could not form a solid solution forms a complex oxide of Ba and Cu, and the complex oxide is scattered in the oxide superconducting bulk.

In order for the oxide superconducting bulk to function as a superconducting magnet, the oxide superconducting bulk needs to have a high critical current density (Jc) even in a magnetic field. In order for the oxide superconducting bulk to have a high critical current density in a magnetic field, the 123 phase needs to be in a single crystal state that does not include a high-angle grain boundary that is superconducting weak link. In order to have property of a higher critical current density Jc, it is necessary to have a pinning center for stopping magnetic flux movement. The 211 phase that is finely dispersed functions as this pinning center, and the 211 phase is preferably dispersed more finely in large numbers. As described above, Pt, Rh, and Ce act to promote the refinement of the 211 phase. Further, it is known that compounds such as $BaCeO_3$, $BaSiO_3$, $BaGeO_3$, and $BaSnO_3$ may function as pinning centers. In addition, as the non-superconducting phase such as the 211 phase is finely dispersed in the 123 phase that is easily cleaved, the non-superconducting phase is important in mechanically strengthening the superconductor and causing the superconductor to function as a bulk material.

Here, the proportion of the 211 phase in the 123 phase is preferably, for example, 5 to 35 volume% in view of the properties of the critical current density (Jc) and the mechanical strength. About 5 to 20 volume% of voids (air bubbles) with about 50 to 500 $\mu$m in size are commonly present in the oxide superconducting bulk. Further, Ag can be added to the oxide superconducting bulk, in addition to the elements described above. When Ag is further added, the oxide superconducting bulk contains Ag or Ag compound having a particle size of about 1 to 500 $\mu$m in an amount of exceeding 0 volume% and 25 volume% or less depending on the amount of Ag added.

The oxide superconducting bulk after crystal growth has an amount of oxygen deficiency (x) of about 0.5, and thus exhibits a semiconductor-like change in resistivity with temperature. By annealing such a bulk after crystal growth in an oxygen atmosphere at a temperature of 623 K to 873 K for about 100 hours depending on each RE type, oxygen is taken into the oxide superconducting bulk and the amount of oxygen deficiency (x) becomes equal to or less than 0.2. As a result, the oxide superconducting bulk after annealing exhibits excellent superconducting properties. At this time, a twin crystal structure is formed in the superconducting phase, and in the present specification, the term "single crystalline" also includes such a twin crystal structure.

In addition, the term "superconducting bulk" in the present specification means a superconducting bulk that partially or entirely includes an oxide superconducting bulk that has a fine oxide structure for exhibiting the properties of the superconductor described above. For example, the term "superconducting bulk" may include a bulk entirely composed of an oxide superconductor (that is, "bulk"), and a stacked body composed of a combination of an oxide superconducting bulk and a non-superconducting bulk (that is, "stacked body").

In the present specification, the term "bulk" is described as generally meaning the oxide superconducting bulk, but when it is not particularly necessary to distinguish between the "bulk" and "stacked body", these may be collectively referred to "bulk". In a case of simply describing "bulk" or the like, its shape (ring shape or columnar shape) is not limited.

[1-3. Configuration of Magnetization System]

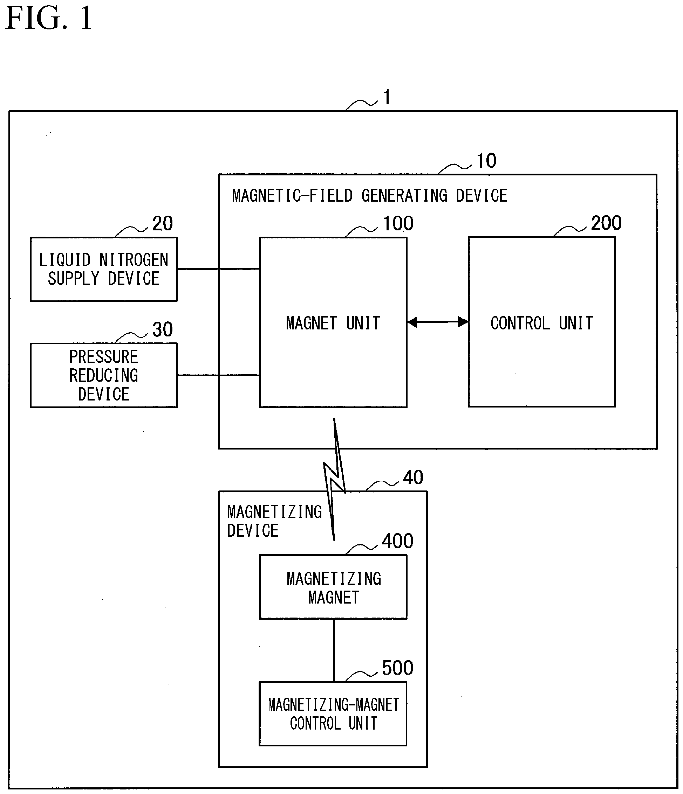

Next, a magnetization system 1 to which a magnetic-field generating device for NMR according to the present embodiment can be applied will be described. Fig. 1 is a block diagram of the magnetization system 1 to which the magnetic-field generating device for NMR according to the embodiment can be applied.

The magnetization system 1 to which the magnetic-field generating device for NMR according to the present embodiment can be applied includes a magnetic-field generating device for NMR 10, a liquid nitrogen supply device 20, a pressure reducing device 30, and a magnetizing device 40.

The magnetic-field generating device for NMR 10 is a device that generates a magnetic field used for NMR analysis, and corresponds to the magnetic-field generating device for NMR according to the present embodiment. The magnetic-field generating device for NMR 10 includes a magnet unit 100 and a control unit 200. Since the details of the magnet unit 100 and the control unit 200 will be described later, detailed description thereof is omitted here.

The liquid nitrogen supply device 20 is connected to the magnetic-field generating device for NMR 10, and supplies liquid nitrogen for cooling an oxide superconducting bulk included in the magnet unit 100 of the magnetic-field generating device for NMR 10. The liquid nitrogen supply device 20 includes a container storing liquid nitrogen, a pump for sending liquid nitrogen from the container to the magnetic-field generating device for NMR 10, a pipe, a valve, and the like. As the container storing liquid nitrogen and the pump for sending liquid nitrogen, conventional containers for storing liquid nitrogen and conventional pumps for sending liquid nitrogen can be used. Similarly, existing pipes and valves that are used for sending liquid nitrogen are appropriately used as the pipes, valves, and the like that constitute the liquid nitrogen supply device 20. In the following description, a pressure reducing valve is used as an example of a pressure reducing unit and a supply valve is used as an example of a supply unit, but a check valve may be used instead of these valves.

The pressure reducing device 30 is connected to the magnetic-field generating device for NMR 10, and depressurizes the magnet unit 100 of the magnetic-field generating device for NMR 10. An existing device is used as the pressure reducing device 30, and for example, a vacuum pump or the like is used. The pressure reducing device 30 can include, for example, a rotary pump and a buffer tank connected to the rotary pump. A valve may be attached to a pipe connecting the rotary pump and the buffer tank. The rotary pump included in the pressure reducing device 30 depressurizes the internal space of the buffer tank to a predetermined pressure. The pressure in the buffer tank is controlled by the operation of the rotary pump, and the opening and closing of the valve described above. A first cold insulation layer 1101 included in the magnet unit 100, which will be described later, is cooled by being depressurized by the pressure reducing device 30.

The magnetizing device 40 magnetizes the oxide superconducting bulk included in the magnet unit 100 of the magnetic-field generating device for NMR 10. The magnetizing device 40 includes a magnetizing magnet 400 (magnetizing unit) and a magnetizing-magnet control unit 500.

A superconducting coil obtained by winding a superconductor wire rod in a coil shape is used for the magnetizing magnet 400. Examples of the superconductor wire rod used for the magnetizing magnet 400 include a metal-based low-temperature superconductor, an oxide-based superconductor, and an iron-based superconductor. Examples of the metal-based low-temperature superconductor include niobium-titanium alloy and niobium-tin alloy. Examples of the oxide-based superconductor may include a bismuth-based superconductor and an RE-based superconductor. The magnetizing magnet 400 may be disposed in a container filled with liquid helium, or may be installed in a refrigerating machine that cools the magnetizing magnet 400. The inner diameter of the inner space of the magnetizing magnet 400 is larger than the outer diameter of an outer tank 1108 of the magnet unit 100 according to the present embodiment. The magnet unit 100 is disposed in the internal space of the magnetizing magnet 400.

The magnetizing-magnet control unit 500 controls the magnetizing magnet 400, thus causing the magnetizing magnet 400 to generate and remove an external magnetic field. Specifically, the magnetizing-magnet control unit 500 controls the magnetizing magnet 400 to generate an external magnetic field by causing a current to flow from an external power supply to the magnetizing magnet 400.

[1-4. Configuration of Magnetic-Field Generating Device for NMR 10]

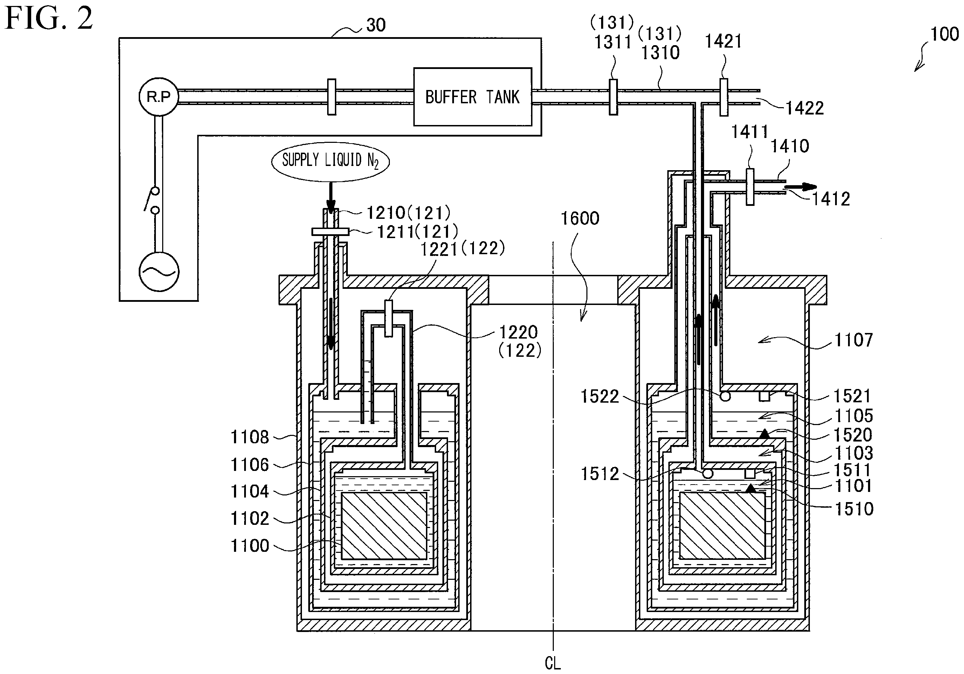

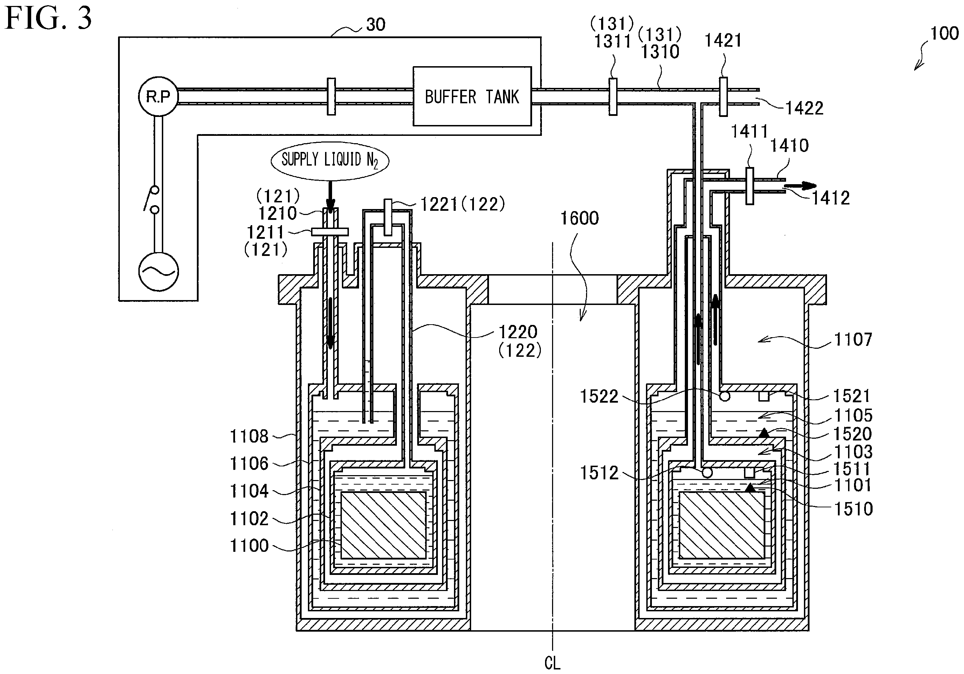

Next, the magnetic-field generating device for NMR according to the present embodiment will be described with reference to Figs. 2 and 3. Fig. 2 is a schematic view for explaining the magnetic-field generating device for NMR 10 according to the present embodiment. Fig. 3 is a schematic view illustrating another aspect of the magnetic-field generating device for NMR 10.

The magnetic-field generating device for NMR 10 according to the present embodiment includes at least the magnet unit 100 that generates a magnetic field in a bore space 1600, and further includes the control unit 200 as necessary. An alternate long and short dash line CL illustrated in Figs. 2 and 3 is the center line of the bore space 1600.

The magnet unit 100 includes an oxide superconducting bulk 1100 that has a ring shape. The magnet unit 100 further includes an inner tank 1102, a first intermediate tank 1104 arranged to include the inner tank 1102, a second intermediate tank 1106 arranged to further include the first intermediate tank 1104, and the outer tank 1108 arranged to further include the second intermediate tank 1106. The inner tank 1102, the first intermediate tank 1104, the second intermediate tank 1106, and the outer tank 1108 each have a hollow ring shape. The magnet unit 100 also includes the first cold insulation layer 1101, a first heat insulation layer 1103, a second cold insulation layer 1105, and a second heat insulation layer 1107. With such a structure, heat penetration into the first cold insulation layer is suppressed, the temperature of the first cold insulation layer is kept more stably for a longer period of time, and the temperature of a bulk magnet is stabilized, so that a magnetic field generated by the bulk magnet is stabilized accordingly. The bulk magnet thus functions as a cooled magnet of NMR magnets.

The oxide superconducting bulk 1100 has a structure in which a 211 phase is dispersed in a single crystalline 123 phase, as described above. The oxide superconducting bulk 1100 is housed inside the inner tank 1102 that is hollow and has a ring shape.

The inner tank 1102 is arranged inside the first intermediate tank 1104 that is hollow and has a ring shape. The first heat insulation layer 1103 is arranged between the inner tank 1102 and the first intermediate tank 1104. The first heat insulation layer 1103 is in a vacuum state, and is preferably kept, for example, at a degree of vacuum on the order of $10^{-5}$ Pa. Further, super insulation formed of a stacked body of aluminum foil and a spacer or the like is preferably inserted in the first heat insulation layer 1103. The first heat insulation layer 1103 suppresses heat transfer between the first cold insulation layer 1101 and the second cold insulation layer 1105 to be described later. As the super insulation is inserted in the first heat insulation layer 1103, radiant heat can be blocked. With such a structure, heat penetration into the first cold insulation layer is suppressed, the temperature of the first cold insulation layer is kept more stably for a longer period of time, and thus the bulk magnet functions as the cooled magnet of NMR magnets.

The first cold insulation layer 1101 that is configured to be capable of storing nitrogen in at least one of liquid, gas, and solid states is arranged around the oxide superconducting bulk 1100 in the inner tank 1102. A first connection port to which a supply pipe for supplying liquid nitrogen is connected and a second connection port to which a discharge pipe for discharging nitrogen from the first cold insulation layer 1101 is connected are formed at an upper portion of the inner tank 1102. The first connection port is connected to, for example, one end of a first supply pipe 1220 to be described later or one end of a third supply pipe 1230 to be described in a third embodiment. Further, the second connection port may be connected to a pipe that causes the first cold insulation layer 1101 and the outside of the magnet unit 100 to communicate with each other, and, for example, one end of a first pressure reducing pipe 1310 extending to the outside of the inner tank 1102 may be connected the second connection port. The first cold insulation layer 1101 is configured to be capable of being depressurized to a first pressure less than 1 atm ($1.013 \times 10^5$ Pa). As the first cold insulation layer 1101 is depressurized to lower than the first pressure, the temperature of the first cold insulation layer 1101 is lower than 77K. As a result, the oxide superconducting bulk 1100 can be cooled to the critical temperature or lower.

The oxide superconducting bulk 1100 has a structure in which $RE_2BaCuO_5$ is dispersed in single crystalline $REBa_2Cu_3O_{7-x}$ (RE is rare earth element), and in order to continuously and stably form a magnetic field that is a strong magnetic field of 4T or more and has homogeneity for a long period of time, it is necessary to keep the temperature of the oxide superconducting bulk 1100 lower than a liquid nitrogen temperature (77 K).

If liquid helium is used as a refrigerant, the boiling point of liquid helium is 4.2 K at 1 atm, and thus the oxide superconducting bulk 1100 is sufficiently cooled without depressurization and has a high critical current density (Jc). It is numerically possible to stably form a magnetic field that is a strong magnetic field of 4T or more and has homogeneity. However, since a bulk is difficult to undergo complex machining with materials having high electrical conductivity and high thermal conductivity such as copper and aluminum, the bulk tends to be magnetically unstable at an extremely low temperature such as 4.2 K, and a sharp decrease in a magnetized magnetic field, which is called "quench" easily occurs. It is not desirable to cool the oxide superconducting bulk 1100 to 4.2 K or lower by depressurizing liquid helium because quench occurs more easily.

When liquid nitrogen is used as the refrigerant for the oxide superconducting bulk 1100, a large specific heat is obtained at 77 K and thus quench does not occur in normal magnetization. It is important to increase the critical current density (Jc) at 77 K for use through depressurization and cooling.

The first intermediate tank 1104 is arranged inside the second intermediate tank 1106 that is hollow and has a ring shape. The second cold insulation layer 1105 configured to be capable of storing liquid nitrogen is arranged between the first intermediate tank 1104 and the second intermediate tank 1106. The pressure of the second cold insulation layer 1105 is atmospheric pressure. The first intermediate tank 1104 preferably includes an extending portion extending upward from an upper surface of the first intermediate tank 1104 along the first pressure reducing pipe 1310. An upper end of the extending portion is closed, and the first heat insulation layer 1103 is arranged inside the extending portion. The extending portion has, for example, a cylindrical shape with the upper end closed, the inner diameter of the extending portion is larger than the outer diameter of the first pressure reducing pipe 1310, and the first pressure reducing pipe 1310 is arranged inside the extending portion so as to preferably achieve a double structure. As this double structure is achieved, the first heat insulation layer 1103 is arranged between the extending portion and the first pressure reducing pipe 1310. As a result, heat transfer between the second cold insulation layer 1105 and the first pressure reducing pipe 1310 is suppressed. The shape of the extending portion is not limited to a cylindrical shape, and any shape is possible as long as the double structure is achieved. With such a structure, heat penetration into the first cold insulation layer is suppressed, the temperature of the first cold insulation layer is kept stable for a longer period of time, and the temperature of the bulk magnet is stabilized, so that a magnetic field generated by the bulk magnet is stabilized. Th bulk magnet thus functions as the cooled magnet of NMR magnets.

The second intermediate tank 1106 is arranged inside the outer tank 1108 that is hollow and has a ring shape. The second heat insulation layer 1107 is arranged between the second intermediate tank 1106 and the outer tank 1108. The second heat insulation layer 1107 is in a vacuum state, and is preferably kept, for example, at a degree of vacuum on the order of $10^{-5}$ Pa. Further, super insulation formed of a stacked body of aluminum foil and a spacer or the like is preferably inserted in the second heat insulation layer 1107. The second heat insulation layer 1107 suppresses heat transfer between the second cold insulation layer 1105 and the external space of the outer tank 1108. As the super insulation is inserted in the second heat insulation layer 1107, radiant heat can be blocked. With such a structure, the temperature of the bulk magnet is stabilized and thus a magnetic field generated by the bulk magnet is stabilized. Th bulk magnet thus functions as the cooled magnet of NMR magnets.

As described above, the inner tank 1102, the first intermediate tank 1104, the second intermediate tank 1106, and the outer tank 1108 are arranged so that the first intermediate tank 1104 includes the inner tank 1102, the second intermediate tank 1106 includes the first intermediate tank 1104, and the outer tank 1108 includes the second intermediate tank 1106. With such an arrangement, the first cold insulation layer 1101 arranged inside the inner tank 1102 can be isolated from the second cold insulation layer 1105 arranged between the first intermediate tank 1104 and the second intermediate tank 1106. Consequently, as will be described later, liquid nitrogen is supplied to the second cold insulation layer 1105 to reduce the temperature of the oxide superconducting bulk 1100 housed in the first cold insulation layer 1101, and then liquid nitrogen is supplied to the first cold insulation layer 1101, so that it is possible to suppress cracking of the oxide superconducting bulk 1100 due to thermal shock. The first heat insulation layer 1103 and the second heat insulation layer 1107 may partially communicate with each other.

The magnet unit 100 according to the present embodiment further includes a second supply unit (second supply pipe 1210 and second supply valve 1211 provided in second supply pipe 1210) configured to allow the liquid nitrogen supply device 20, which is externally disposed, to communicate with the second cold insulation layer 1105 so as to be capable of supplying liquid nitrogen to the second cold insulation layer, a first supply unit (first supply pipe 1220 and first supply valve 1221 provided in first supply pipe 1220) configured to allow the second cold insulation layer 1105 to communicate with the first cold insulation layer 1101 so as to be capable of supplying liquid nitrogen to the first cold insulation layer, and a first pressure reducing unit (first pressure reducing pipe 1310 and first pressure reducing valve 1311 provided in first pressure reducing pipe 1310) configured to allow the first cold insulation layer 1101 to communicate with the pressure reducing device 30, which is externally disposed, so as to be capable of depressurizing the first cold insulation layer. Further, the magnet unit 100 may include a discharge pipe 1410 that causes the external space of the outer tank 1108 to communicate with the second cold insulation layer 1105, and a first discharge valve 1411 provided in the discharge pipe 1410.

One end of the second supply pipe 1210 is connected to the liquid nitrogen supply device 20, and the other end of the second supply pipe 1210 is inserted into the outer tank 1108 and connected to an upper surface of the second intermediate tank 1106. The second supply pipe 1210 is preferably a vacuum heat insulation pipe. The second supply valve 1211 is attached to the second supply pipe 1210. The second supply valve 1211 may be attached to the second supply pipe 1210 outside the outer tank 1108, or may be attached to the second supply pipe 1210 in the second heat insulation layer 1107. When the second supply valve 1211 is attached to the second supply pipe 1210 inside the outer tank 1108, the second supply valve 1211 is preferably a solenoid valve.

One end of the first supply pipe 1220 may be connected to the upper surface of the second intermediate tank 1106, and the other end of the first supply pipe 1220 may be connected to an upper surface of the inner tank 1102. The first supply valve 1221 may be attached to a portion of the first supply pipe 1220 arranged in the second heat insulation layer 1107. Further, the first supply pipe 1220 may be provided so as to connect the first intermediate tank 1104 to the inner tank 1102. At this time, the first supply valve 1221 may be attached to a portion of the first supply pipe 1220 arranged in the first heat insulation layer 1103. Further, a part of the first supply pipe 1220 may be arranged outside the outer tank 1108, for example, as illustrated in Fig. 3, and the first supply valve 1221 may be provided in the portion of the first supply pipe 1220 arranged outside the outer tank 1108. As illustrated in Fig. 3, when the first supply pipe 1220 extending to the outside of the outer tank 1108 causes the first cold insulation layer 1101 to communicate with the second cold insulation layer 1105, a vacuum heat insulation pipe is preferably used as the first supply pipe 1220, and a valve with high heat insulation property is preferably used as the first supply valve 1221. Since the first supply valve 1221 is provided in the portion of the first supply pipe 1220 arranged outside the outer tank 1108, a user can manually open and close the first supply valve 1221.

The discharge pipe 1410 is connected to the upper surface of the second intermediate tank 1106 at one end, and has a first discharge port 1412 exposed to the external space of the outer tank 1108 at the other end. The inner diameter of the discharge pipe 1410 is preferably larger than the outer diameter of the first pressure reducing pipe 1310 for example, and the discharge pipe 1410 preferably includes a portion in which the discharge pipe 1410 and the first pressure reducing pipe 1310 constitute a double structure. Further, when the extending portion of the first intermediate tank 1104 is provided, the inner diameter of the discharge pipe 1410 is preferably larger than the outer diameter of the extending portion. In this case, the triple structure is formed by the discharge pipe 1410, the extending portion, and the first pressure reducing pipe 1310 at a position where the extending portion is provided. Above the upper end of the extending portion, the discharge pipe 1410 and the first pressure reducing pipe 1310 constitute a double structure. In the portion having the double structure, when heat enters the discharge pipe 1410 from the outside of the magnet unit 100, the entering heat can move to the first pressure reducing pipe 1310. As a result, it is possible to suppress heat penetration from the other end of the discharge pipe 1410 exposed to the external space of the outer tank 1108 to the first cold insulation layer 1101. Further, even if the discharge pipe 1410 and the first pressure reducing pipe 1310 do not constitute a double structure, it is only required to provide, above the extending portion, a structure that allows heat entering the discharge pipe 1410 from the outside to move to the first pressure reducing pipe 1310. With such a structure, heat penetration into the first cold insulation layer is suppressed, the temperature of the first cold insulation layer is kept more stably for a longer period of time, and the temperature of the bulk magnet is stabilized, so that a magnetic field generated by the bulk magnet is stabilized. The bulk magnet thus functions as the cooled magnet of NMR magnets.

The first discharge valve 1411 is attached to a portion of the discharge pipe 1410 arranged outside the outer tank 1108. The first discharge valve 1411 is normally open, and the pressure of the second cold insulation layer 1105 is kept constant. The first discharge valve 1411 may be attached to the discharge pipe 1410 inside the outer tank 1108.

One end of the first pressure reducing pipe 1310 is connected to the upper surface of the inner tank 1102, and the other end is connected to the pressure reducing device 30. The first pressure reducing pipe 1310 extends upward, for example, from the upper surface of the inner tank 1102 to the outside of the inner tank 1102, and one end of the first pressure reducing pipe 1310 arranged outside the inner tank 1102 is connected to a buffer tank that constitutes the pressure reducing device 30. In addition, the first pressure reducing pipe 1310 branches at a portion of the first pressure reducing pipe 1310 arranged outside the outer tank 1108, and a second discharge port 1422 exposed to the outside of the outer tank 1108 may be provided at an end of the branched portion. At this time, a second discharge valve 1421 is preferably provided between the branched portion of the first pressure reducing pipe 1310 and the second discharge port 1422. The second discharge port 1422 allows liquid nitrogen excessively supplied to the first cold insulation layer 1101 to be discharged to the outside of the magnet unit 100.

The magnet unit 100 may further include a first nitrogen amount sensor 1510 that detects the amount of nitrogen in the first cold insulation layer 1101, a first temperature sensor 1511 that detects the temperature of the first cold insulation layer 1101, a second nitrogen amount sensor 1520 that detects the amount of nitrogen in the second cold insulation layer 1105, and a second temperature sensor 1521 that detects the temperature of the second cold insulation layer 1105.

The first nitrogen amount sensor 1510 and the first temperature sensor 1511 are provided on the first cold insulation layer 1101. A known level sensor can be used as the first nitrogen amount sensor 1510, and for example, a capacitance level sensor, a semiconductor level sensor, an optical fiber level sensor, or the like can be used. Alternatively, a plurality of temperature sensors may be used as the first nitrogen amount sensor 1510. Specifically, by arranging a plurality of temperature sensors in the height direction of the first cold insulation layer 1101 and detecting the temperature at the position where each temperature sensor is arranged, a user can check the amount of liquid nitrogen in the first cold insulation layer. An existing low temperature sensor can be used as the first temperature sensor 1511.

The second nitrogen amount sensor 1520 and the second temperature sensor 1521 are provided on the second cold insulation layer 1105. A sensor similar to the first nitrogen amount sensor 1510 may be used as the second nitrogen amount sensor 1520. A sensor similar to the first temperature sensor 1511 may be used as the second temperature sensor 1521.

The control unit 200 controls the opening and closing of various valves included in the magnet unit 100 to supply, transfer, and depressurize liquid nitrogen. Specifically, the control unit 200 supplies liquid nitrogen to the first cold insulation layer 1101 and the second cold insulation layer 1105, depressurizes the first cold insulation layer 1101, and exhausts the second cold insulation layer 1105. The control unit 200 preferably controls the second supply valve 1211 and the first supply valve 1221 based on the amount of nitrogen detected by the first nitrogen amount sensor 1510 and the second nitrogen amount sensor 1520. In addition, the control unit 200 may control the first pressure reducing valve 1311 based on the temperature of the first cold insulation layer detected by the first temperature sensor 1511. The control unit 200 can also control the first discharge valve 1411 so as to exhaust nitrogen vaporized from the second cold insulation layer to the external space of the magnet unit 100.

The magnet unit 100 preferably further includes a first pressure sensor 1512 on the first cold insulation layer 1101 for the purpose of detecting the pressure of the first cold insulation layer 1101. As the control unit 200 controls the opening and closing of the first pressure reducing valve 1311 based on the pressure of the first cold insulation layer 1101 detected by the first pressure sensor 1512, the pressure of the first cold insulation layer 1101 can be kept at the first pressure. The pressure of the first cold insulation layer 1101 can also be controlled by detecting the pressure of the first pressure reducing pipe 1310, assuming that the pressure is the same as the pressure of the first pressure reducing pipe 1310 near the first pressure reducing valve 1311.

The magnet unit 100 preferably further includes a second pressure sensor 1522 on the second cold insulation layer 1105 for the purpose of detecting the pressure of the second cold insulation layer 1105. As the control unit 200 controls the opening and closing of the first discharge valve 1411 based on the pressure of the second cold insulation layer 1105 detected by the second pressure sensor 1522, it is possible to prevent air from flowing from the outside of the outer tank 1108 through the discharge pipe 1410 into the second cold insulation layer 1105.

[1-5. Operation of Magnetic-Field Generating Device for NMR 10]

(1-5-1. Operation During Magnetization)

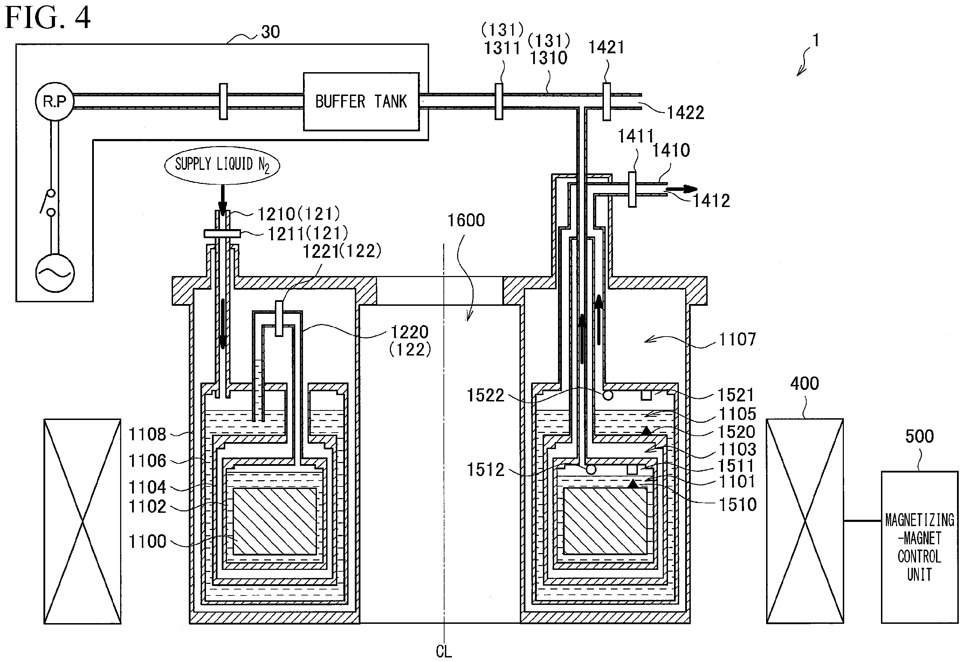

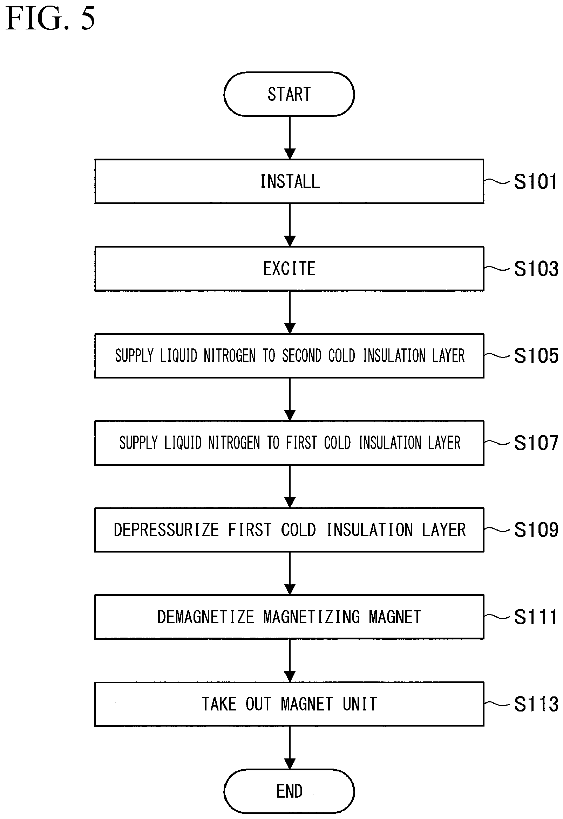

The configuration of the magnetic-field generating device for NMR 10 according to the present embodiment has been described in detail. Next, an operation of the magnetic-field generating device for NMR 10 according to the present embodiment will be described with reference to Figs. 4 and 5. Fig. 4 is a schematic view for explaining the operation of the magnetic-field generating device for NMR 10 according to the present embodiment. Fig. 5 is a flowchart for explaining an operation of the magnetic-field generating device for NMR 10 according to the present embodiment when magnetized.

First, as illustrated in Fig. 4, the magnet unit 100 is installed in the hollow space of the magnetizing magnet 400 (S101). At this time, the magnet unit 100 is arranged so that the center position of the magnetic field of the magnetizing magnet 400 matches the center position of the oxide superconducting bulk 1100 included in the magnet unit 100 in a height direction. Next, a current flows from an external power source into the magnetizing magnet 400 to excite the magnetizing magnet 400, so that an external magnetic field that has high intensity and high homogeneity is generated in the hollow space of the magnetizing magnet 400 (SI03).

Next, liquid nitrogen is supplied to the second cold insulation layer 1105 (S105). Specifically, the control unit 200 opens the second supply valve 1211 and the first discharge valve 1411, and closes the first supply valve 1221, so that liquid nitrogen is supplied from the liquid nitrogen supply device 20, which is externally disposed, to the second cold insulation layer 1105 through the second supply pipe 1210. The second supply valve 1211 is controlled based on the amount of liquid nitrogen in the second cold insulation layer 1105, which is detected by the second nitrogen amount sensor 1520 provided on the second cold insulation layer 1105. Liquid nitrogen is supplied to the second cold insulation layer 1105 until the amount of liquid nitrogen in the second cold insulation layer 1105 reaches a predetermined amount, and then the control unit 200 closes the second supply valve 1211. The second supply valve 1211 may be closed after liquid nitrogen overflows from the first discharge port 1412 to the outside. The nitrogen vaporized from the second cold insulation layer 1105 is exhausted to the outside through the discharge pipe 1410. It is also possible to connect the liquid nitrogen supply device 20 to the discharge pipe 1410 and supply liquid nitrogen to the second cold insulation layer 1105 through the discharge pipe 1410. However, when liquid nitrogen is supplied from the discharge pipe 1410 to the second cold insulation layer 1105 to discharge nitrogen gas not from the discharge pipe 1410 but from the second supply pipe 1210, heat enters the second supply pipe 1210 from the outside and thus external heat enters the first cold insulation layer 1101 and the temperature of the first cold insulation layer 1101 may rise. Consequently, nitrogen gas is preferably discharged from the second cold insulation layer 1105 through the discharge pipe 1410.

Next, liquid nitrogen is supplied to the first cold insulation layer 1101 (SI07). Specifically, the control unit 200 closes the first discharge valve 1411, and opens the second supply valve 1211 and the first supply valve 1221, so that liquid nitrogen is supplied from the second cold insulation layer 1105 to the first cold insulation layer 1101 through the first supply pipe 1220. The second supply valve 1211 and the first supply valve 1221 are controlled based on the amount of liquid nitrogen in the first cold insulation layer 1101, which is detected by the first nitrogen amount sensor 1510 provided on the first cold insulation layer 1101. Liquid nitrogen is supplied to the first cold insulation layer 1101 until the amount of liquid nitrogen in the first cold insulation layer 1101 reaches a predetermined amount, and then the control unit 200 closes the second supply valve 1211 and the first supply valve 1221. At the time of supplying liquid nitrogen, when an excessive amount of liquid nitrogen is supplied to the first cold insulation layer 1101, the excessive amount of liquid nitrogen may overflow from the second discharge port 1422 to the outside of the magnet unit 100. Further, at the time of supplying liquid nitrogen, the pressure reducing device 30 is removed from the first pressure reducing pipe 1310, and when an excessive amount of liquid nitrogen is supplied to the first cold insulation layer 1101, the excessive amount of liquid nitrogen may overflow from the one end of the first pressure reducing pipe 1310 that is open because the pressure reducing device 30 is removed therefrom to the outside of the magnet unit 100. Regarding the operation of completing the supply of liquid nitrogen to the first cold insulation layer 1101, after liquid nitrogen overflows from the one end of the first pressure reducing pipe 1310 having the pressure reducing device 30 removed therefrom or the second discharge port 1422 to the outside, the second supply valve 1211, the first supply valve 1221, and the first pressure reducing valve 1311 or the second discharge valve 1421 may be closed.

The first cold insulation layer 1101 is then depressurized to a predetermined pressure (S109). Specifically, the control unit 200 opens the first pressure reducing valve 1311 with the first supply valve 1221 closed, and the first cold insulation layer 1101 is depressurized to the first pressure that is less than 1 atm by the pressure reducing device 30 through the first pressure reducing pipe 1310. As the first cold insulation layer 1101 is depressurized to the first pressure, the temperature of the first cold insulation layer 1101 is lower than 77.3 K. The first cold insulation layer 1101 maybe depressurized to about 0.123 atm that is the triple point of nitrogen to be in a state where solid nitrogen, liquid nitrogen, and gaseous nitrogen coexist at a temperature is 63.1 K, or the first cold insulation layer 1101 may be depressurized to less than 0.123 atm to be in a state where solid nitrogen and gaseous nitrogen coexist. When the first pressure is less than 0.123 atm, solid nitrogen is generated, and the solid nitrogen may adhere to an inner surface of the first pressure reducing pipe 1310, which may cause a decrease in the efficiency of depressurizing the first cold insulation layer 1101 by the pressure reducing device 30. As the first cold insulation layer 1101 is depressurized to the first pressure and cooled, the oxide superconducting bulk 1100 housed in the inner tank 1102 is cooled to the critical temperature or lower. Further, in order to keep the temperature of the first cold insulation layer 1101 at a predetermined temperature or lower, the control unit 200 preferably controls the first supply valve 1221 so that a small amount of liquid nitrogen is supplied to the first cold insulation layer 1101 for several times.

After the oxide superconducting bulk 1100 is cooled to the critical temperature or lower, the magnetizing magnet 400 is demagnetized, and the external magnetic field generated by the magnetizing magnet 400 is removed (Sill). As a result, the external magnetic field generated by the magnetizing magnet 400, which has high intensity and high homogeneity, is copied to the oxide superconducting bulk 1100, and thus the oxide superconducting bulk 1100 is magnetized.

After the magnetization, the magnet unit 100 is taken out of the internal space of the magnetizing magnet 400 (S113). When the magnetized magnet unit 100 is taken out of the inner space of the magnetizing magnet 400, in order to remove the residual magnetic field of the magnetizing magnet 400, the temperature of the magnetizing magnet 400 is preferably increased to cause the magnetizing magnet 400 to be in a non-superconducting state, and then the magnet unit 100 is taken out. When the magnetizing magnet 400 is cooled by liquid helium, a method of extracting liquid helium is effective as a method of increasing the temperature of the magnetizing magnet 400. When a magnetizing magnet that is conduction-cooled by a refrigerating machine is used as the magnetizing magnet 400, it is effective to temporarily stop the operation of the refrigerating machine.

In addition to the above method, the following method can also be used as the method for magnetizing the oxide superconducting bulk 1100. The magnet unit 100 is arranged in the internal space of the magnetizing magnet 400 where a magnetic field is not generated, while liquid nitrogen is in the first cold insulation layer 1101 and the second cold insulation layer 1105. Subsequently, for example, by pressurizing the liquid nitrogen in the first cold insulation layer 1101 from the outside to increase the temperature of the first cold insulation layer 1101 to about 90 K and then exciting the magnetizing magnet 400, the oxide superconducting bulk 1100, which is in a normally conductive state, may be arranged in the external magnetic field generated by the magnetizing magnet 400. By demagnetizing the magnetizing magnet 400, the external magnetic field is copied to the oxide superconducting bulk 1100 arranged in the external magnetic field, and thus the oxide superconducting bulk 1100 can be magnetized.

As described above, in supplying liquid nitrogen to the magnet unit 100, after step S105 of supplying liquid nitrogen to the second cold insulation layer 1105, step S107 of supplying liquid nitrogen to the first cold insulation layer 1101 is preferably performed. As liquid nitrogen is supplied to the second cold insulation layer 1105 first, the temperature of the magnet unit 100 decreases, and the temperature of the oxide superconducting bulk 1100 decreases accordingly. After the temperature of the oxide superconducting bulk 1100 decreases, liquid nitrogen is supplied to the first cold insulation layer 1101 in which the oxide superconducting bulk 1100 with reduced temperature is housed, so that it is possible to suppress cracking of the oxide superconducting bulk 1100 due to thermal shock. With the operation described above, the magnetic-field generating device for NMR 10 according to the present embodiment can supply a sufficient amount of liquid nitrogen to the first cold insulation layer 1101 before magnetization. Consequently, in magnetizing the magnetic-field generating device for NMR 10, the magnetization can be completed without replenishing liquid nitrogen to the first cold insulation layer 1101 during the magnetization. Therefore, the oxide superconducting bulk 1100 can be efficiently magnetized. A strong magnetic field is generated by the magnetizing magnet 400 around the magnetizing magnet 400 during magnetization. However, since it is unnecessary to replenish liquid nitrogen to the first cold insulation layer 1101 during magnetization, devices, tools, or the like that are used for replenishing liquid nitrogen and affected by a strong magnetic field need not to be disposed near the magnetizing magnet 400. As a result, it is possible to suppress operational problems and accidents during magnetization.

(1-5-2. Operation at Time of Replenishing Liquid Nitrogen in NMR Analysis)

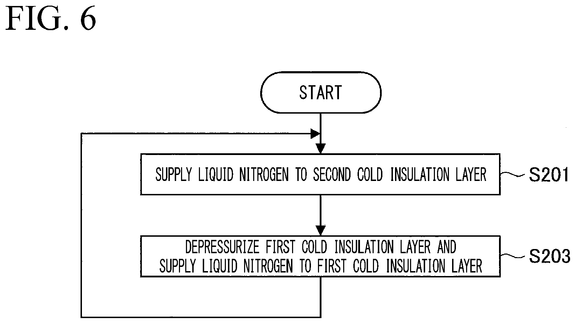

As the magnetic-field generating device for NMR 10 according to the present embodiment is used for NMR analysis, the liquid nitrogen in the first cold insulation layer 1101 and the second cold insulation layer 1105 decreases. An operation of the magnetic-field generating device for NMR 10 at the time of replenishing liquid nitrogen in NMR analysis will be described with reference to Fig. 6. Fig. 6 is a flowchart for explaining an operation of the magnetic-field generating device for NMR 10 according to the present embodiment at the time of replenishing liquid nitrogen. In supplying nitrogen to the depressurized first cold insulation layer, it is excellent in view of the use efficiency of a refrigerant and workability to supply, to the first cold insulation layer, liquid nitrogen that is stored in the second cold insulation layer and functions as a thermal anchor that suppresses heat penetration into the first cold insulation layer, not to directly supply liquid nitrogen from the outside. When liquid nitrogen is directly supplied from an external liquid nitrogen tank, liquid nitrogen temporarily flows in a pipe at room temperature and the pipe with a certain distance needs to be cooled to the liquid nitrogen temperature by a refrigerant, and thus liquid nitrogen is wasted. On the other hand, when liquid nitrogen is supplied from the second cold insulation layer to the first cold insulation layer by using a pipe in a heat-insulated device, liquid nitrogen flows in a short pipe that is already cooled and connects the first cold insulation layer to the second cold insulation layer, so that liquid nitrogen is hardly wasted. In addition, since the second cold insulation layer is at atmospheric pressure and the first cold insulation layer is depressurized, liquid nitrogen can be easily supplied to the first cold insulation layer by adjusting the opening and closing of a valve or the like, resulting in excellent workability. As described above, it can be said that the structure of the present invention is basically excellent in view of the use efficiency of a refrigerant and workability.

First, when the amount of liquid nitrogen in the second cold insulation layer 1105, which is detected by the second nitrogen amount sensor 1520, is less than a predetermined amount, liquid nitrogen is supplied to the second cold insulation layer 1105 (S201). Specifically, the control unit 200 opens the second supply valve 1211 and the first discharge valve 1411, and closes the first supply valve 1221, so that liquid nitrogen is supplied from the liquid nitrogen supply device 20, which is externally disposed, to the second cold insulation layer 1105 through the second supply pipe 1210. At this time, the second cold insulation layer 1105 has atmospheric pressure. The first cold insulation layer 1101 is then depressurized, and liquid nitrogen is supplied to the depressurized first cold insulation layer 1101 (S203). Specifically, the control unit 200 closes the first supply valve 1221, opens the first pressure reducing valve 1311, and depressurizes the first cold insulation layer 1101 by the pressure reducing device 30 that is externally disposed. Next, the control unit 200 closes the second supply valve 1211 and the first discharge valve 1411 and opens the first supply valve 1221, so that liquid nitrogen is supplied from the second cold insulation layer 1105 to the first cold insulation layer 1101 through the first supply pipe 1220. The control unit 200 can supply liquid nitrogen based on the temperature of the first cold insulation layer 1101 detected by the first temperature sensor 1511 so that the temperature of the first cold insulation layer 1101 is kept at a temperature lower than a predetermined preset temperature. For example, the control unit 200 can set the preset temperature of the first cold insulation layer 1101 and a valve operating temperature that is a temperature at which the first supply valve 1221 operates. The valve operating temperature is lower than the preset temperature of the first cold insulation layer 1101. When the temperature of the first cold insulation layer 1101 detected by the first temperature sensor 1511 is equal to or higher than the valve operating temperature, the control unit 200 closes the first supply valve 1221. The control unit 200 can open the first supply valve 1221 when the first cold insulation layer 1101 is depressurized by the pressure reducing device 30 and the temperature of the first cold insulation layer 1101 decreases to be lower than the valve operating temperature. With the operation described above, the control unit 200 can keep the temperature of the first cold insulation layer 1101 in a predetermined preset temperature range, and supply liquid nitrogen from the second cold insulation layer 1105 to the first cold insulation layer 1101 through the first supply pipe 1220. After the first nitrogen amount sensor 1510 detects that liquid nitrogen is sufficiently supplied to the first cold insulation layer 1101, the control unit 200 closes the first supply valve 1221. After that, the control unit 200 checks that the pressure of the second cold insulation layer 1105 is equal to or higher than the atmospheric pressure by using the second pressure sensor 1522, and then can open the first discharge valve 1411. Consequently, it is possible to prevent air from flowing into the second cold insulation layer 1105 from the outside of the outer tank 1108 through the discharge pipe 1410.

As S201 and S203 described above are repeated each time the amount of liquid nitrogen in the first cold insulation layer 1101 decreases, it is possible to maintain a magnetic field that has high intensity and high homogeneity for a long period of time. Consequently, the magnetic-field generating device for NMR 10 according to the present embodiment can easily obtain a magnetic field with high homogeneity without using liquid helium or a refrigerating machine that generates vibrations that cause noise in NMR analysis.

In supplying nitrogen to the first cold insulation layer 1101, it is desirable to reduce the pressure of the first cold insulation layer 1101 to a third pressure that is lower than the first pressure, and then supply nitrogen.

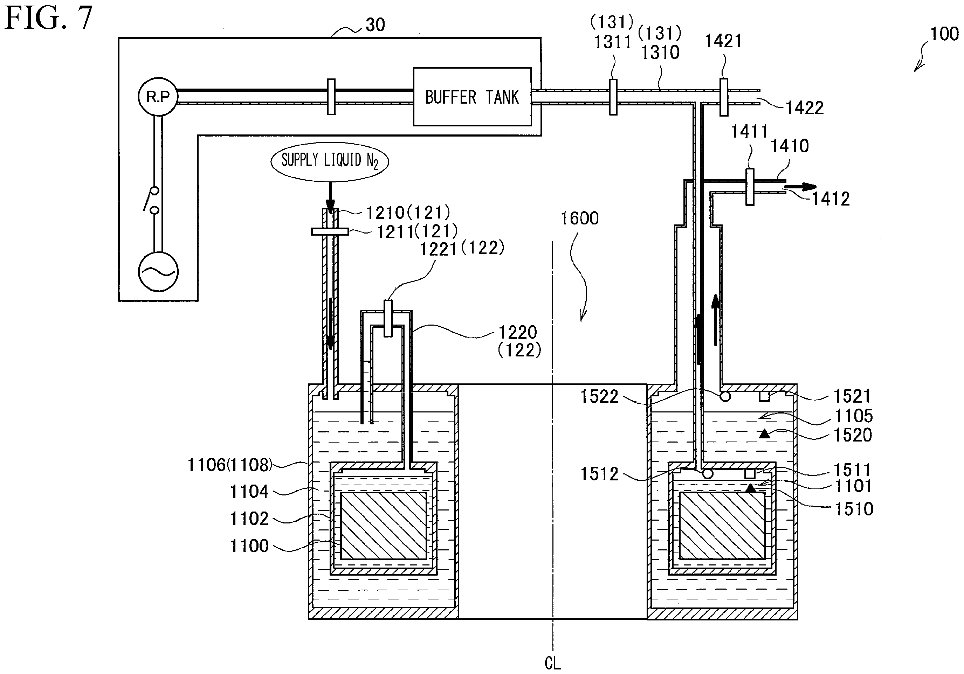

The magnetic-field generating device for NMR 10 according to the present embodiment is configured to have the first heat insulation layer 1103 and the second heat insulation layer 1107, but as in the modification illustrated in Fig. 7, the first heat insulation layer and the second heat insulation layer may be omitted. In this case, the outer side of the second intermediate tank 1106 functions as the outer tank 1108.

With such a structure, the heat transfer suppression effect by a heat insulation layer is reduced, but the first cold insulation layer 1101 is depressurized to less than the first pressure, and thus the temperature of the first cold insulation layer 1101 is lower than 77 K. As a result, the oxide superconducting bulk 1100 can be cooled to the critical temperature or lower. Further, heat penetration into the first cold insulation layer due to heat radiation is suppressed, the temperature of the first cold insulation layer is kept more stably for a longer period of time, and the temperature of the bulk magnet is stabilized, so that a magnetic field generated by the bulk magnet is stabilized. The bulk magnet thus functions as the cooled magnet of NMR magnets.

<2. Second Embodiment

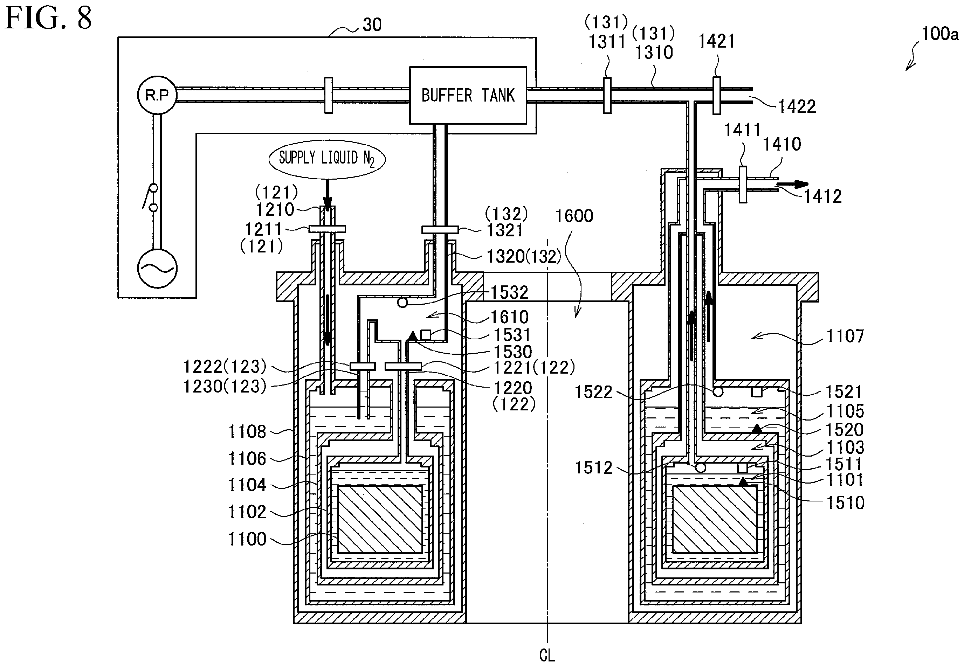

Next, a magnetic-field generating device for NMR 10a according to a second embodiment will be described with reference to Fig. 8. Fig. 8 is a schematic view for explaining the magnetic-field generating device for NMR 10a according to the present embodiment. Since the NMR device to which the magnetic-field generating device for NMR 10a according to the present embodiment can be applied, and the oxide superconducting bulk 1100 used in the magnetic-field generating device for NMR 10a are similar to those described in the first embodiment, detailed description thereof is omitted here. In addition, since the magnetization system 1 to which the magnetic-field generating device for NMR according to the present embodiment can be applied is also similar to that described in the first embodiment, detailed description is also omitted here.

[2-1. Magnetic-Field Generating Device for NMR 10a]

The magnetic-field generating device for NMR 10a according to the present embodiment includes at least a magnet unit 100a that generates a magnetic field in the bore space 1600, and further includes the control unit 200 as necessary.

In the magnet unit 100a, since the oxide superconducting bulk 1100, the inner tank 1102, the first intermediate tank 1104, the second intermediate tank 1106, and the outer tank 1108, the first cold insulation layer 1101, the first heat insulation layer 1103, the second cold insulation layer 1105, and the second heat insulation layer 1107 are similar to those described in the first embodiment, detailed description thereof is omitted here. The magnet unit 100a further includes the second supply unit (second supply pipe 1210 and second supply valve 1211 provided in second supply pipe 1210) that causes the liquid nitrogen supply device 20, which is externally disposed, to communicate with the second cold insulation layer 1105, a first supply unit that causes the second cold insulation layer 1105 to communicate with the first cold insulation layer 1101, and the first pressure reducing unit (first pressure reducing pipe 1310 and first pressure reducing valve 1311 provided in first pressure reducing pipe 1310) that causes the first cold insulation layer 1101 to communicate with the pressure reducing device 30, which is externally disposed. The first supply unit includes a precooling chamber 1610 configured to be capable of supplying depressurized liquid nitrogen and a third supply unit that supplies liquid nitrogen to the precooling chamber 1610. Preferably, the first supply unit further includes the second discharge valve 1421.

The magnet unit 100a may further include the discharge pipe 1410 that causes the external space of the outer tank 1108 to communicate with the second cold insulation layer 1105, the first discharge valve 1411 provided in the discharge pipe 1410, the first nitrogen amount sensor 1510 that detects the amount of nitrogen in the first cold insulation layer 1101, the first temperature sensor 1511 that detects the temperature of the first cold insulation layer 1101, the second nitrogen amount sensor 1520 that detects the amount of nitrogen in the second cold insulation layer 1105, and the second temperature sensor 1521 that detects the temperature of the second cold insulation layer 1105. Since the second supply pipe 1210, the second supply valve 1211, the first supply pipe 1220, the first supply valve 1221, the first pressure reducing pipe 1310, the first pressure reducing valve 1311, the discharge pipe 1410, the first discharge valve 1411, the second discharge valve 1421, the first nitrogen amount sensor 1510, the first temperature sensor 1511, the second nitrogen amount sensor 1520, and the second temperature sensor 1521 are similar to those described in the first embodiment, detailed description thereof is omitted here.

In the present embodiment, the precooling chamber 1610 communicates with the first cold insulation layer 1101 via the first supply pipe 1220 including the first supply valve 1221, and with the second cold insulation layer 1105 via the third supply pipe 1230 including a third supply valve 1231. The precooling chamber 1610 is preferably provided in the first heat insulation layer 1103 or the second heat insulation layer 1107. As the precooling chamber 1610 is provided in the first heat insulation layer 1103 or the second heat insulation layer 1107, it is possible to suppress heat flowing from the external space of the magnet unit 100a to the precooling chamber 1610. The precooling chamber 1610 includes a third pressure reducing unit (third pressure reducing 1320 communicating with pressure reducing device, which is externally disposed, and third pressure reducing valve 1321 provided in third pressure reducing pipe) configured to be capable of depressurizing the precooling chamber 1610. The pressure reducing device 30 may be used as an external pressure reducing device connected to one end of the third pressure reducing pipe 1320, or another pressure reducing device may be used. Here, it is assumed that the pressure reducing device 30 is used in the magnetization system 1.

In the precooling chamber 1610, the liquid nitrogen in the precooling chamber 1610 is cooled. Specifically, the precooling chamber 1610 is depressurized to a second pressure that is higher than a first pressure, which is the pressure of the first cold insulation layer, and lower than 1 atm by the pressure reducing device 30 communicating with the precooling chamber 1610 through the third pressure reducing pipe 1320. The liquid nitrogen in the precooling chamber 1610 is cooled to a temperature according to the pressure of the precooling chamber 1610.

The magnet unit 100a preferably further includes a third nitrogen amount sensor 1530 that detects the amount of nitrogen in the precooling chamber 1610 and a third temperature sensor 1531 that detects the temperature of the precooling chamber 1610.

The third nitrogen amount sensor 1530 and the third temperature sensor 1531 are provided in the precooling chamber 1610. A level sensor that is similar to the level sensor described in the first embodiment can be used as the third nitrogen amount sensor 1530. An existing low temperature sensor can be used as the third temperature sensor 1531.

The magnet unit 100 preferably further includes a third pressure sensor 1532 that detects the pressure in the precooling chamber 1610 in the precooling chamber 1610. The control unit 200 operates, for example, the third pressure reducing valve 1321 based on the pressure in the precooling chamber 1610 detected by the third pressure sensor 1532, thus controlling the pressure in the precooling chamber 1610.

The control unit 200 is similar to the control unit described in the first embodiment, but further has a function of controlling the first supply valve 1221 and the third pressure reducing valve 1321.

[2-2. Operation of Magnetic-Field Generating Device for NMR 10a]

(2-2-1. Operation During Magnetization)

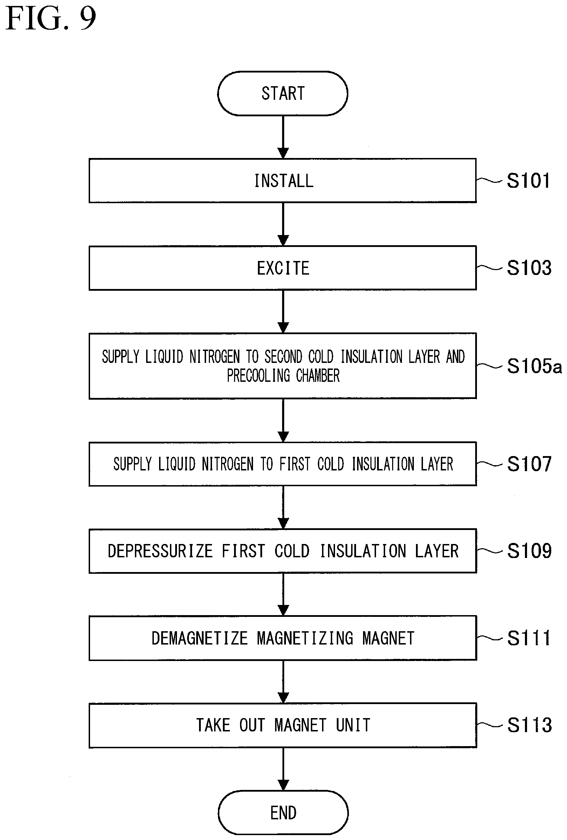

Next, an operation of the magnetic-field generating device for NMR 10a according to the present embodiment when magnetized will be described with reference to Fig. 9. Fig. 9 is a flowchart for explaining the operation of the magnetic-field generating device for NMR 10a according to the present embodiment when magnetized. Since S101, S103, and S109 to S113 illustrated in Fig. 9 are similar to the operation of the magnetic-field generating device for NMR 10 according to the first embodiment when magnetized, detailed description thereof is omitted here.

After the magnetizing magnet 400 is excited in S103 and an external magnetic field is generated in the space inside the magnetizing magnet 400, liquid nitrogen is supplied to the second cold insulation layer 1105 and the precooling chamber 1610 in the magnet unit 100a (SI05a). Specifically, the control unit 200 opens the second supply valve 1211, the first supply valve 1221, and the first discharge valve 1411, and closes the third supply valve 1222, so that liquid nitrogen is supplied from the liquid nitrogen supply device 20, which is externally disposed, to the second cold insulation layer 1105 through the second supply pipe 1210, and is further supplied from the second cold insulation layer 1105 to the precooling chamber 1610 through the first supply pipe 1220. The second supply valve 1211 is preferably controlled based on at least any of the amount of liquid nitrogen in the second cold insulation layer 1105, which is detected by the second nitrogen amount sensor 1520 provided on the second cold insulation layer 1105, and the amount of liquid nitrogen in the precooling chamber 1610, which is detected by the third nitrogen amount sensor 1530 provided in the precooling chamber 1610. Liquid nitrogen is supplied to the second cold insulation layer 1105 and the precooling chamber 1610 until the amount of liquid nitrogen in the second cold insulation layer 1105 and the amount of liquid nitrogen in the precooling chamber 1610 reach a predetermined amount, and then the control unit 200 closes the second supply valve 1211. The control unit 200 may close the second supply valve 1211 after liquid nitrogen overflows from the first discharge port 1412 to the outside of the magnet unit 100a. The nitrogen vaporized from the second cold insulation layer 1105 is exhausted to the outside through the discharge pipe 1410.

Next, liquid nitrogen is supplied from the precooling chamber 1610 to the first cold insulation layer 1101 (S107). Specifically, the control unit 200 closes the third pressure reducing valve 1321 and the first discharge valve 1411, and opens the second supply valve 1211, the first supply valve 1221, and the third supply valve 1222, so that liquid nitrogen is supplied from the second cold insulation layer 1105 to the first cold insulation layer 1101 through the first supply pipe 1220. The second supply valve 1211, the first supply valve 1221, and the third supply valve 1222 are preferably controlled based on the amount of liquid nitrogen in the first cold insulation layer 1101, which is detected by the first nitrogen amount sensor 1510 provided on the first cold insulation layer 1101. Liquid nitrogen is supplied to the first cold insulation layer 1101 until the amount of liquid nitrogen in the first cold insulation layer 1101 reaches a predetermined amount, and then the control unit 200 closes the second supply valve 1211, the first supply valve 1221, and the third supply valve 1222. At the time of supplying liquid nitrogen, when an excessive amount of liquid nitrogen is supplied to the first cold insulation layer 1101, the excessive amount of liquid nitrogen may overflow from the second discharge port 1422 to the outside of the magnet unit 100a. Further, at the time of supplying liquid nitrogen, the pressure reducing device 30 is removed from the first pressure reducing pipe 1310, and when an excessive amount of liquid nitrogen is supplied to the first cold insulation layer 1101, the excessive amount of liquid nitrogen may overflow from the one end of the first pressure reducing pipe 1310 that is open because the pressure reducing device 30 is removed therefrom to the outside of the magnet unit 100a. Regarding the operation of completing the supply of liquid nitrogen to the first cold insulation layer 1101, after liquid nitrogen overflows from the one end of the first pressure reducing pipe 1310 having the pressure reducing device 30 removed therefrom or the second discharge port 1422 to the outside, the second supply valve 1211, the first supply valve 1221, and the first pressure reducing valve 1311 or the second discharge valve 1421 may be closed.

(2-2-2. Operation at Time of Replenishing Liquid Nitrogen in NMR Analysis)

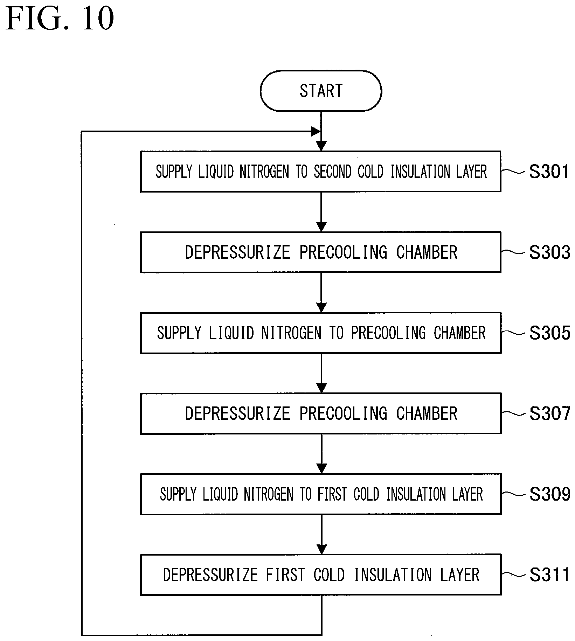

The operation of the magnetic-field generating device for NMR 10a according to the present embodiment when magnetized has been described. An operation of the magnetic-field generating device for NMR 10a at the time of replenishing liquid nitrogen in NMR analysis will be described with reference to Fig. 10. Fig. 10 is a flowchart for explaining an operation of the magnetic-field generating device for NMR 10a according to the present embodiment at the time of replenishing liquid nitrogen. Since S301 illustrated in Fig. 10 is similar to S201 in the operation of the magnetic-field generating device for NMR 10 according to the first embodiment at the time of supplying liquid nitrogen, detailed description thereof is omitted here. In supplying nitrogen to the depressurized first cold insulation layer, it is excellent in view of the use efficiency of a refrigerant and workability to supply, to the first cold insulation layer, liquid nitrogen that is stored in the second cold insulation layer and functions as a thermal anchor that suppresses heat penetration into the first cold insulation layer, not to directly supply liquid nitrogen from the outside. When liquid nitrogen is directly supplied from an external liquid nitrogen tank, liquid nitrogen temporarily flows in a pipe at room temperature and the pipe with a certain distance needs to be cooled to the liquid nitrogen temperature by a refrigerant, and thus liquid nitrogen is wasted. On the other hand, when liquid nitrogen is supplied from the second cold insulation layer to the first cold insulation layer through the precooling chamber 1610 by using a pipe in a heat-insulated device, liquid nitrogen flows in a short pipe that is already cooled and connects the first cold insulation layer to the second cold insulation layer, so that liquid nitrogen is hardly wasted. In addition, since the second cold insulation layer is at atmospheric pressure and is depressurized and cooled in the precooling chamber, liquid nitrogen can be easily supplied to the first cold insulation layer through the precooling chamber 1610 by adjusting the opening and closing of a valve or the like, resulting in excellent workability. As described above, it can be said that the structure of the present invention is basically excellent in view of the use efficiency of a refrigerant and workability.

Further, the present embodiment is different from the first embodiment at the time of replenishing liquid nitrogen in that liquid nitrogen is precooled to a temperature close to the temperature of the second cold insulation layer in the precooling chamber 1610, and thus fluctuations in the temperature of the second cold insulation layer can be suppressed.

After S301, the precooling chamber 1610 is depressurized to a predetermined pressure (S303). Specifically, the control unit 200 closes the second supply valve 1211, the first supply valve 1221, the third supply valve 1222, and the first discharge valve 1411, and opens the third pressure reducing valve 1321 provided in the third pressure reducing pipe 1320. The control unit 200 closes the third pressure reducing valve 1321 after the pressure in the precooling chamber 1610 is reduced to a predetermined pressure or lower by the pressure reducing device 30 through the third pressure reducing pipe 1320. The pressure in the precooling chamber 1610 is preferably detected by the third pressure sensor 1532 provided in the precooling chamber 1610. The pressure in the precooling chamber 1610 is preferably depressurized to a second pressure that is higher than the first pressure, which is the pressure of the first cold insulation layer 1101 and is lower than 1 atm, and that is lower than 1 atm.

Next, liquid nitrogen is supplied from the second cold insulation layer 1105 to the precooling chamber 1610 (S305). Specifically, the control unit 200 opens the third supply valve 1222, and closes the second supply valve 1211, the first supply valve 1221, the third pressure reducing valve 1321, and the first discharge valve 1411, so that liquid nitrogen is supplied from the second cold insulation layer 1105 to the precooling chamber 1610 through the third supply pipe 1230. The liquid nitrogen in the second cold insulation layer 1105 is transferred to the precooling chamber 1610 by utilizing the pressure difference between the second cold insulation layer 1105 and the precooling chamber 1610. The third supply valve 1222 is controlled based on the amount of liquid nitrogen in the precooling chamber 1610, which is detected by the third nitrogen amount sensor 1530 provided in the precooling chamber 1610.

Next, the precooling chamber 1610 is depressurized (S307). Specifically, the control unit 200 opens the third pressure reducing valve 1321, and closes the first supply valve 1221 and the third supply valve 1222, so that the precooling chamber 1610 is depressurized to the second pressure that is higher than the first pressure and is lower than 1 atm by the pressure reducing device 30 through the third pressure reducing pipe 1320. The temperature of the liquid nitrogen in the precooling chamber 1610 decreases as the liquid nitrogen in the precooling chamber 1610 is depressurized.

Next, liquid nitrogen is supplied from the precooling chamber 1610 to the first cold insulation layer 1101 (S309). Specifically, the control unit 200 closes the third supply valve 1222 and the third pressure reducing valve 1321, and opens the first supply valve 1221, so that liquid nitrogen is supplied from the precooling chamber 1610 to the first cold insulation layer 1101 through the first supply pipe 1220. The liquid nitrogen in the precooling chamber 1610 is transferred to the first cold insulation layer 1101 by utilizing the pressure difference between the first cold insulation layer 1101 and the precooling chamber 1610. The first supply valve 1221 is controlled based on the amount of liquid nitrogen in the first cold insulation layer 1101, which is detected by the first nitrogen amount sensor 1510 provided on the first cold insulation layer 1101. Liquid nitrogen is supplied to the first cold insulation layer 1101 until the amount of liquid nitrogen in the first cold insulation layer 1101 reaches a predetermined amount, and then the control unit 200 closes the first supply valve 1221. The control unit 200 can supply liquid nitrogen based on the temperature of the first cold insulation layer 1101 detected by the first temperature sensor 1511 so as to prevent the temperature of the first cold insulation layer 1101 from being equal to or higher than a predetermined temperature. Specifically, the control unit 200 can control the first supply valve 1221 based on the temperature of the first cold insulation layer 1101 detected by the first temperature sensor 1511 so as to keep the temperature of the first cold insulation layer 1101 in a predetermined preset temperature range. For example, the control unit 200 can set the valve operating temperature that is a temperature at which the first supply valve 1221 operates. When the temperature of the first cold insulation layer 1101 detected by the first temperature sensor 1511 is equal to or higher than the valve operating temperature, the control unit 200 closes the first supply valve 1221. The control unit 200 can open the first supply valve 1221 when the first cold insulation layer 1101 is depressurized by the pressure reducing device 30 and the temperature of the first cold insulation layer 1101 decreases to be lower than the valve operating temperature. With the operation described above, the control unit 200 can keep the temperature of the first cold insulation layer 1101 at a temperature lower than a predetermined temperature, and supply liquid nitrogen from the precooling chamber 1610 to the first cold insulation layer 1101 through the first supply pipe 1220. After liquid nitrogen is sufficiently supplied to the first cold insulation layer 1101, the control unit 200 closes the first supply valve 1221.

After that, the control unit 200 depressurizes the first cold insulation layer 1101 to the first pressure (S311). Specifically, when the pressure of the first cold insulation layer 1101 at the valve operating temperature described above is higher than the first pressure, the control unit 200 opens the first pressure reducing valve 1311 and closes the first supply valve 1221, so that the first cold insulation layer 1101 is depressurized to the first pressure by the pressure reducing device 30 through the first pressure reducing pipe 1310. Further, the control unit 200 checks that the pressure of the second cold insulation layer 1105 is equal to or higher than the atmospheric pressure by using the second pressure sensor 1522, and then opens the first discharge valve 1411. As S301 to S311 described above are repeated as necessary, it is possible to maintain a magnetic field that has high intensity and high homogeneity for a long period of time. In supplying nitrogen to the first cold insulation layer 1101, it is preferable to reduce the pressure of the first cold insulation layer 1101 to a third pressure that is lower than the first pressure, and then supply nitrogen to the first cold insulation layer 1101. As the pressure of the first cold insulation layer 1101 is reduced to the third pressure, the pressure after liquid nitrogen is supplied from the precooling chamber 1610 to the first cold insulation layer 1101 can be controlled to be equal to or lower than the first pressure. As a result, a user can perform NMR analysis without waiting for the pressure of the first cold insulation layer 1101 to decrease to the first pressure after liquid nitrogen is replenished.

When liquid nitrogen is replenished only to the second cold insulation layer 1105, only S301 described above may be performed.

<3. Third Embodiment

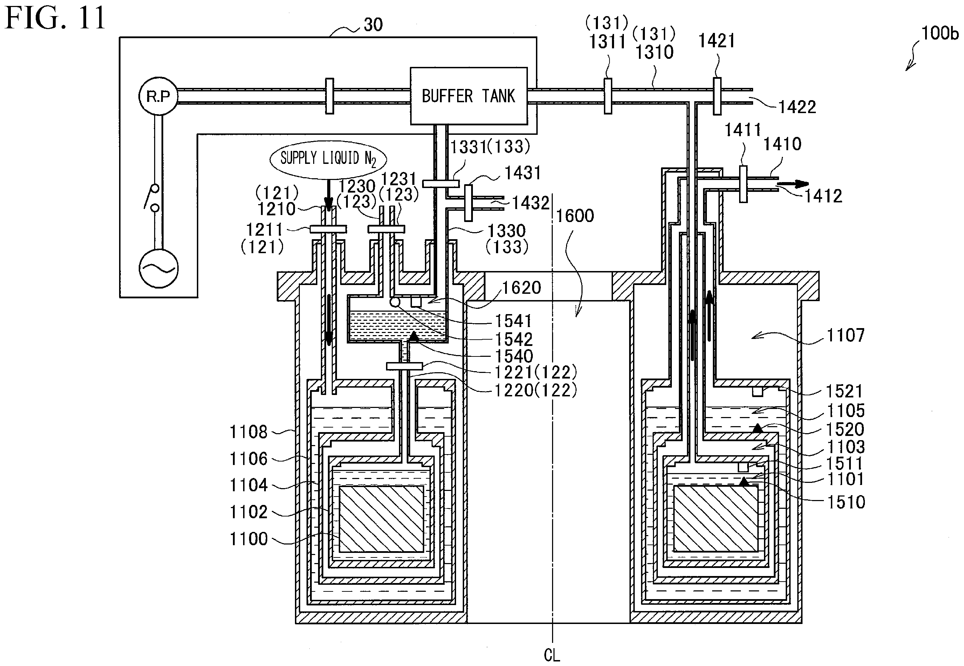

Next, a magnetic-field generating device for NMR 10b according to a third embodiment will be described with reference to Fig. 11. Fig. 11 is a schematic view for explaining the magnetic-field generating device for NMR 10b according to the present embodiment. Since the NMR device to which the magnetic-field generating device for NMR 10b according to the present embodiment can be applied, and the oxide superconducting bulk 1100 used in the magnetic-field generating device for NMR 10b are similar to those described in the first embodiment, detailed description thereof is omitted here. In addition, since the magnetization system 1 to which the magnetic-field generating device for NMR according to the present embodiment can be applied is similar to that described in the first embodiment, detailed description is also omitted here.

[3-1. Magnetic-Field Generating Device for NMR 10b]

The magnetic-field generating device for NMR 10b according to the present embodiment includes at least a magnet unit 100b that generates a magnetic field in the bore space 1600, and further includes the control unit 200 as necessary.

In the magnet unit 100b, since the oxide superconducting bulk 1100, the inner tank 1102, the first intermediate tank 1104, the second intermediate tank 1106, and the outer tank 1108, the first cold insulation layer 1101, the first heat insulation layer 1103, the second cold insulation layer 1105, and the second heat insulation layer 1107 are similar to those described in the first embodiment, detailed description thereof is omitted here. The magnet unit 100b further includes the second supply unit (second supply pipe 1210 and second supply valve 1211 provided in second supply pipe 1210) that causes the liquid nitrogen supply device 20, which is externally disposed, to communicate with the second cold insulation layer 1105, a first supply unit that causes the liquid nitrogen supply device, which is externally disposed, to communicate with the first cold insulation layer 1101, and the first pressure reducing unit (first pressure reducing pipe 1310 and first pressure reducing valve 1311 provided in first pressure reducing pipe 1310) that causes the first cold insulation layer 1101 to communicate with the pressure reducing device 30, which is externally disposed. The first supply unit includes the precooling chamber 1610 configured to be capable of supplying depressurized liquid nitrogen and the third supply unit that supplies liquid nitrogen to the precooling chamber 1610. Preferably, the first supply unit further includes the second discharge valve 1421. The magnet unit 100b may further include the discharge pipe 1410 that causes the external space of the outer tank 1108 to communicate with the second cold insulation layer 1105, the first discharge valve 1411 provided in the discharge pipe 1410, the first nitrogen amount sensor 1510 that detects the amount of nitrogen in the first cold insulation layer 1101, the first temperature sensor 1511 that detects the temperature of the first cold insulation layer 1101, the second nitrogen amount sensor 1520 that detects the amount of nitrogen in the second cold insulation layer 1105, and the second temperature sensor 1521 that detects the temperature of the second cold insulation layer 1105. Since the second supply pipe 1210, the second supply valve 1211, the first pressure reducing pipe 1310, the first pressure reducing valve 1311, the discharge pipe 1410, the first discharge valve 1411, the second discharge valve 1421, the first nitrogen amount sensor 1510, the first temperature sensor 1511, the second nitrogen amount sensor 1520, and the second temperature sensor 1521 are similar to those described in the first embodiment, detailed description thereof is omitted here.

In the present embodiment, the precooling chamber 1610 communicates with the first cold insulation layer 1101 via the first supply pipe 1220 having the first supply valve 1221, and includes the third supply unit (third supply pipe 1230 and third supply valve 1231 provided in third supply pipe 1230) that communicates with the liquid nitrogen supply device, which is externally disposed, and a third pressure reducing unit (third pressure reducing pipe 1330 and third pressure reducing valve 1331 provided in third pressure reducing pipe 1330). The precooling chamber 1610 is preferably provided in the first heat insulation layer 1103 or the second heat insulation layer 1107. As the precooling chamber 1610 is provided in the first heat insulation layer 1103 or the second heat insulation layer 1107, it is possible to suppress heat flowing from the external space of the magnet unit 100a to the precooling chamber 1610.

One end of the third supply pipe 1230 is connected to the liquid nitrogen supply device 20, and the other end of the third supply pipe 1230 is inserted into the outer tank 1108 and connected to an upper surface of the inner tank 1102. The third supply pipe 1230 is preferably a vacuum heat insulation pipe. The fourth supply valve 1231 is attached to the third supply pipe 1230. The fourth supply valve 1231 may be attached to the third supply pipe 1230 outside the outer tank 1108, or may be attached to the third supply pipe 1230 in the second heat insulation layer 1107. When the fourth supply valve 1231 is attached to the third supply pipe 1230 inside the outer tank 1108, the fourth supply valve 1231 is preferably a solenoid valve. Further, a check valve that is removable when liquid nitrogen is supplied from the liquid nitrogen supply device 20 to the precooling chamber 1620 to be described later may be used as the fourth supply valve 1231 outside the outer tank 1108. As the check valve is used, when the pressure in the precooling chamber 1620 increases due to nitrogen gas, the nitrogen gas in the precooling chamber 1620 is exhausted, so that the pressure increase in the precooling chamber 1620 can be suppressed. Further, as the check valve is used, it is possible to prevent air containing water from flowing into the precooling chamber 1620, freezing, and blocking the pipes constituting the magnetic-field generating device for NMR. The liquid nitrogen supply device 20 may be used as a liquid nitrogen supply device that supplies liquid nitrogen to the precooling chamber 1620, or another liquid nitrogen supply device may be used. Here, it is assumed that the liquid nitrogen supply device 20 is used in the magnetization system 1.

In the third supply pipe 1230 of the magnet unit 100b, the first supply valve 1221 is provided closer to the first cold insulation layer 1101 than the fourth supply valve 1231. In addition, the precooling chamber 1620 is disposed between the fourth supply valve 1231 and the first supply valve 1221 in the third supply pipe 1230. The precooling chamber 1620 is preferably provided in the first heat insulation layer 1103 or the second heat insulation layer 1107. As the precooling chamber 1620 is provided in the first heat insulation layer 1103 or the second heat insulation layer 1107, it is possible to suppress heat flowing from the external space of the magnet unit 100b to the precooling chamber 1620. The precooling chamber 1620 includes the third pressure reducing pipe 1330 communicating with the external pressure reducing device and the third pressure reducing valve 1331 provided in third pressure reducing pipe. The pressure reducing device 30 may be used as an external pressure reducing device connected to one end of the third pressure reducing pipe 1330, or another pressure reducing device may be used. Here, it is assumed that the pressure reducing device 30 is used in the magnetization system 1.

In the precooling chamber 1620, the liquid nitrogen in the precooling chamber 1620 is cooled. Specifically, the precooling chamber 1620 is depressurized to a pressure that is higher than a first pressure, which is the pressure of the first cold insulation layer, and lower than 1 atm by the pressure reducing device 30 that is externally disposed and connected to the precooling chamber 1620 through the third pressure reducing pipe 1330. The liquid nitrogen in the precooling chamber 1620 is cooled to a temperature based on the pressure in the precooling chamber 1620.

In addition, the third pressure reducing pipe 1330 branches at a portion of the third pressure reducing pipe 1330 between the precooling chamber 1620 and the third pressure reducing valve 1331, and a third discharge port 1432 exposed to the outside of the outer tank 1108 may be provided at an end of the branched portion. At this time, a third discharge valve 1431 is preferably provided between the branched portion of the third pressure reducing pipe 1330 and the third discharge port 1432.

The magnet unit 100b preferably further includes a third nitrogen amount sensor 1540 that detects the amount of nitrogen in the precooling chamber 1620 and a third temperature sensor 1541 that detects the temperature of the precooling chamber 1620.

The third nitrogen amount sensor 1540 and the third temperature sensor 1541 are provided in the precooling chamber 1620. A level sensor that is similar to the level sensor described in the first embodiment can be used as the third nitrogen amount sensor 1540. An existing low temperature sensor can be used as the third temperature sensor 1531.

The magnet unit 100b preferably further includes a third pressure sensor 1542 that detects the pressure in the precooling chamber 1620 in the precooling chamber 1620. The control unit 200 preferably operates, for example, the third pressure reducing valve 1331 based on the pressure in the precooling chamber 1620 detected by the third pressure sensor 1542, thus controlling the pressure in the precooling chamber 1620.

The control unit 200 is similar to the control unit described in the first embodiment, but further has a function of controlling the fourth supply valve 1231, the first supply valve 1221, and the third pressure reducing valve 1331.

[3-2. Operation of Magnetic-Field Generating Device for NMR 10b]

(3-2-1. Operation During Magnetization)

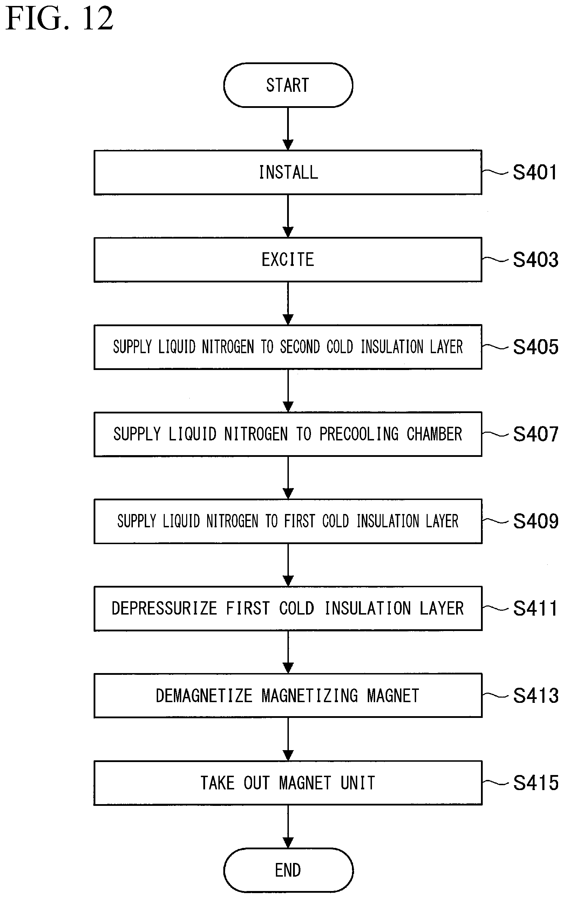

Next, an operation of the magnetic-field generating device for NMR 10b according to the present embodiment when magnetized will be described with reference to Fig. 12. Fig. 12 is a flowchart for explaining the operation of the magnetic-field generating device for NMR 10b according to the present embodiment when magnetized. Since S401, S403, S413 and S415 illustrated in Fig. 12 are similar to S101, S103, S111 and S113 described in the first embodiment, detailed description thereof is omitted here.

After the magnetizing magnet 400 is excited (S403), the control unit 200 opens the second supply valve 1211 and the first discharge valve 1411, so that liquid nitrogen is supplied from the liquid nitrogen supply device 20, which is externally disposed, to the second cold insulation layer 1105 through the second supply pipe 1210 (S405). The second supply valve 1211 is controlled based on the amount of liquid nitrogen in the second cold insulation layer 1105, which is detected by the second nitrogen amount sensor 1520 provided on the second cold insulation layer 1105. After the amount of liquid nitrogen in the second cold insulation layer 1105 reaches a predetermined amount, the control unit 200 closes the second supply valve 1211. The second supply valve 1211 and the first discharge valve 1411 may be closed after liquid nitrogen overflows from the first discharge port 1412 to the outside.

Next, liquid nitrogen is supplied from the liquid nitrogen supply device 20 to the precooling chamber 1620 (S407). Specifically, the control unit 200 opens the fourth supply valve 1231, and closes the first supply valve 1221 and the third pressure reducing valve 1331, so that liquid nitrogen is supplied from the liquid nitrogen supply device 20 to the precooling chamber 1620 through the third supply pipe 1230. The fourth supply valve 1231 is preferably controlled based on the amount of liquid nitrogen in the precooling chamber 1620, which is detected by the third nitrogen amount sensor 1540 provided in the precooling chamber 1620. Liquid nitrogen is supplied to the precooling chamber 1620 until the amount of liquid nitrogen in the precooling chamber 1620 reaches a predetermined amount, and then the control unit 200 closes the fourth supply valve 1231. When an excessive amount of liquid nitrogen is supplied to the precooling chamber 1620, the excessive amount of liquid nitrogen may overflow from the third discharge port 1432 to the outside of the magnet unit 100b. Further, at the time of supplying liquid nitrogen, the pressure reducing device 30 is removed from the third pressure reducing pipe 1330, and when an excessive amount of liquid nitrogen is supplied to the first cold insulation layer 1101, the excessive amount of liquid nitrogen may overflow from the one end of the third pressure reducing pipe 1330 that is open because the pressure reducing device 30 is removed therefrom to the outside of the magnet unit 100b. Regarding the operation of completing the supply of liquid nitrogen to the precooling chamber 1620, after liquid nitrogen overflows from the one end of the third pressure reducing pipe 1330 having the pressure reducing device 30 removed therefrom or the third discharge port 1432 to the outside, the fourth supply valve 1231, the first supply valve 1221, and the third pressure reducing valve 1331 or the third discharge valve 1431 may be closed. Liquid nitrogen is supplied to the precooling chamber 1620 until the amount of liquid nitrogen in the precooling chamber 1620 reaches a predetermined amount, and then the control unit 200 closes the fourth supply valve 1231 and the third discharge valve 1431.

Next, liquid nitrogen is supplied from the precooling chamber 1620 to the first cold insulation layer 1101 (S409). Specifically, the control unit 200 opens the fourth supply valve 1231 and the first supply valve 1221, and closes the third pressure reducing valve 1331 and the third discharge valve 1431, so that precooled liquid nitrogen is supplied from the precooling chamber 1620 to the first cold insulation layer 1101 through the first supply pipe 1220. The first supply valve 1221 is preferably controlled based on the amount of liquid nitrogen in the first cold insulation layer 1101, which is detected by the first nitrogen amount sensor 1510 provided on the first cold insulation layer 1101. Liquid nitrogen is supplied to the first cold insulation layer 1101 until the amount of liquid nitrogen in the first cold insulation layer 1101 reaches a predetermined amount, and then the control unit 200 closes the first supply valve 1221. At the time of supplying liquid nitrogen, when an excessive amount of liquid nitrogen is supplied to the first cold insulation layer 1101, the excessive amount of liquid nitrogen may overflow from the second discharge port 1422 to the outside of the magnet unit 100b. Further, at the time of supplying liquid nitrogen, the pressure reducing device 30 is removed from the first pressure reducing pipe 1310, and when an excessive amount of liquid nitrogen is supplied to the first cold insulation layer 1101, the excessive amount of liquid nitrogen may overflow from the one end of the first pressure reducing pipe 1310 that is open because the pressure reducing device 30 is removed therefrom to the outside of the magnet unit 100b. Regarding the operation of completing the supply of liquid nitrogen to the first cold insulation layer 1101, after liquid nitrogen overflows from the one end of the first pressure reducing pipe 1310 having the pressure reducing device 30 removed therefrom or the second discharge port 1422 to the outside, the fourth supply valve 1231, the first supply valve 1221, and the first pressure reducing valve 1311 or the second discharge valve 1421 may be closed.

In the above description, the liquid nitrogen supplied from the liquid nitrogen supply device 20 is stored in the precooling chamber 1620, and then liquid nitrogen is supplied to the first cold insulation layer 1101, but the supply of liquid nitrogen to the first cold insulation layer 1101 is not limited thereto. For example, any time after liquid nitrogen is supplied to the second cold insulation layer 1105, the control unit 200 may open the fourth supply valve 1231, the first supply valve 1221, and the first pressure reducing valve 1311 or the second discharge valve 1421, and close the third pressure reducing valve 1331 and the third discharge valve 1431, so that liquid nitrogen is supplied from the liquid nitrogen supply device 20 to the precooling chamber 1620 and the first cold insulation layer 1101 through the third supply pipe 1230.

As described above, after step S405 of supplying liquid nitrogen to the second cold insulation layer 1105, step S409 of supplying liquid nitrogen to the first cold insulation layer 1101 is preferably performed. As liquid nitrogen is supplied to the second cold insulation layer 1105 first, the temperature of the magnet unit 100 decreases, and the temperature of the oxide superconducting bulk 1100 decreases accordingly. After that, liquid nitrogen is supplied to the first cold insulation layer 1101 in which the oxide superconducting bulk 1100 with reduced temperature is housed, so that it is possible to suppress cracking of the oxide superconducting bulk 1100 due to thermal shock.

(3-2-2. Operation at Time of Replenishing Liquid Nitrogen in NMR Analysis)

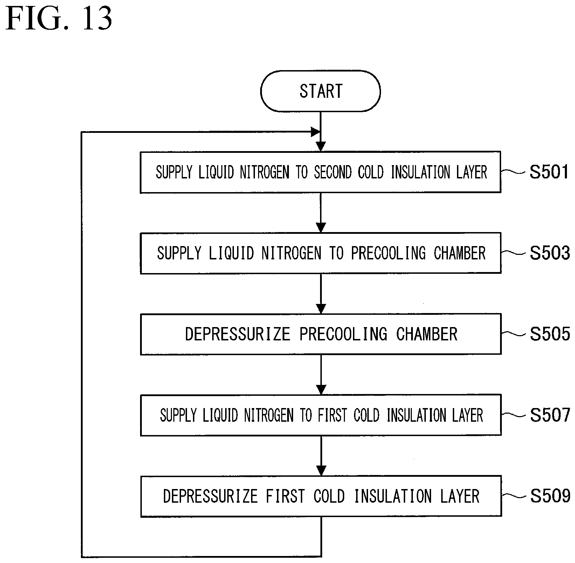

The operation of the magnetic-field generating device for NMR 10b according to the present embodiment when magnetized has been described. An operation of the magnetic-field generating device for NMR 10b at the time of replenishing liquid nitrogen in NMR analysis will be described with reference to Fig. 13. Fig. 13 is a flowchart for explaining an operation of the magnetic-field generating device for NMR 10b according to the present embodiment at the time of replenishing liquid nitrogen. In supplying nitrogen to the depressurized first cold insulation layer, liquid nitrogen is not directly supplied from the outside, but is temporarily precooled to a temperature close to the temperature of the second cold insulation layer in the precooling chamber 1620, and thus fluctuations in the temperature of the second cold insulation layer can be suppressed.

First, when the amount of liquid nitrogen in the second cold insulation layer 1105, which is detected by the second nitrogen amount sensor 1520, is less than a predetermined amount, liquid nitrogen is supplied to the second cold insulation layer 1105 (S501). Specifically, the control unit 200 opens the second supply valve 1211 and the first discharge valve 1411, so that liquid nitrogen is supplied from the liquid nitrogen supply device 20, which is externally disposed, to the second cold insulation layer 1105 through the second supply pipe 1210. The second supply valve 1211 is controlled based on the amount of liquid nitrogen in the second cold insulation layer 1105, which is detected by the second nitrogen amount sensor 1520 provided on the second cold insulation layer 1105. After the amount of liquid nitrogen in the second cold insulation layer 1105 reaches a predetermined amount, the control unit 200 closes the second supply valve 1211. The second supply valve 1211 and the first discharge valve 1411 may be closed after liquid nitrogen overflows from the first discharge port 1412 to the outside. At this time, the second cold insulation layer 1105 has atmospheric pressure.

Next, liquid nitrogen is supplied to the precooling chamber 1620 (S503). Specifically, the control unit 200 opens the fourth supply valve 1231 and the third discharge valve 1431 and closes the first supply valve 1221 and the third pressure reducing valve 1331, so that liquid nitrogen is supplied from the liquid nitrogen supply device 20 to the precooling chamber 1620 through the third supply pipe 1230. The fourth supply valve 1231 is controlled based on the amount of liquid nitrogen in the precooling chamber 1620, which is detected by the third nitrogen amount sensor 1540 provided in the precooling chamber 1620. At this time, the control unit 200 may close the fourth supply valve 1231 and the third discharge valve 1431 after checking that liquid nitrogen overflows from the third discharge port 1432 to the outside, instead of detecting the amount of liquid nitrogen by the third nitrogen amount sensor 1540. Alternatively, in a state where the pressure reducing device 30 is removed from the third pressure reducing pipe 1330 in advance, the control unit 200 may open the fourth supply valve 1231 and the third pressure reducing valve 1331, and close the first supply valve 1221 and the third discharge valve 1431, so that liquid nitrogen is supplied from the liquid nitrogen supply device 20 to the precooling chamber 1620 through the third supply pipe 1230. After liquid nitrogen overflows from one end of the third pressure reducing pipe 1330 having the pressure reducing device 30 removed therefrom to the outside, the fourth supply valve 1231 may be closed.

Next, the precooling chamber 1620 is depressurized (S505). The control unit 200 opens the third pressure reducing valve 1331, and closes the fourth supply valve 1231, the first supply valve 1221, the first pressure reducing valve 1311, and the third discharge valve 1431, so that the precooling chamber 1620 is depressurized to the second pressure that is higher than the first pressure and is lower than 1 atm by the pressure reducing device 30 through the third pressure reducing pipe 1330, and the liquid nitrogen in the precooling chamber 1620 is cooled.

Next, liquid nitrogen is supplied from the precooling chamber 1620 to the first cold insulation layer 1101 (S507). Specifically, the control unit 200 closes the fourth supply valve 1231, the first pressure reducing valve 1311, the third pressure reducing valve 1331, and the third discharge valve 1431, and opens the first supply valve 1221, so that liquid nitrogen is supplied from the precooling chamber 1620 through the first cold insulation layer 1101 through the third supply pipe 1230. The liquid nitrogen in the precooling chamber 1620 is transferred to the first cold insulation layer 1101 by utilizing the pressure difference between the first cold insulation layer 1101 and the precooling chamber 1620. The first supply valve 1221 is controlled based on the amount of liquid nitrogen in the first cold insulation layer 1101, which is detected by the first nitrogen amount sensor 1510 provided on the first cold insulation layer 1101. Liquid nitrogen is supplied to the first cold insulation layer 1101 until the amount of liquid nitrogen in the first cold insulation layer 1101 reaches a predetermined amount, and then the control unit 200 closes the first supply valve 1221.

After that, the control unit 200 depressurizes the first cold insulation layer 1101 to the first pressure (S509). Specifically, since the pressure of the first cold insulation layer 1101 after liquid nitrogen is supplied from the precooling chamber 1620 thereto is higher than the first pressure, the control unit 200 opens the first pressure reducing valve 1311 and closes the first supply valve 1221, so that the first cold insulation layer 1101 is depressurized to the first pressure by the pressure reducing device 30 through the first pressure reducing pipe 1310. Further, the control unit 200 checks that the pressure of the second cold insulation layer 1105 is equal to or higher than the atmospheric pressure by using the second pressure sensor 1522, and then opens the first discharge valve 1411. As S501 to S509 described above are repeated, it is possible to maintain a magnetic field that has high intensity and high homogeneity for a long period of time.

When the amount of liquid nitrogen in the second cold insulation layer 1105, which is detected by the second nitrogen amount sensor 1520 provided on the second cold insulation layer 1105, is equal to or more than a predetermined amount in S501, liquid nitrogen is not supplied to the second cold insulation layer 1105 and S503 is performed.

According to the magnetic-field generating device for NMR 10b of the present embodiment, the liquid nitrogen precooled in the precooling chamber 1620 can be supplied to the first cold insulation layer 1101, so that liquid nitrogen can be supplied to the first cold insulation layer 1101 while the temperature of the first cold insulation layer 1101 is kept at a low temperature without depressurizing the first cold insulation layer 1101 to a pressure equal to or lower than the triple point of nitrogen before liquid nitrogen is supplied to the first cold insulation layer 1101 with a reduced amount of liquid nitrogen. Further, it is possible to omit an operation of replenishing a small amount of liquid nitrogen to the first cold insulation layer 1101 for several times so as to prevent the temperature of the first cold insulation layer 1101 from being equal to or higher than a temperature desired by a user. The liquid nitrogen that is supplied from the liquid nitrogen supply device 20, which is externally disposed, to the first cold insulation layer 1101 and cooled in the precooling chamber 1620 is replenished to the first cold insulation layer 1101. Consequently, the decrease amount of liquid nitrogen in the second cold insulation layer 1105 is equal to the amount of vaporized nitrogen discharged from the discharge pipe 1410.

<4. Fourth Embodiment

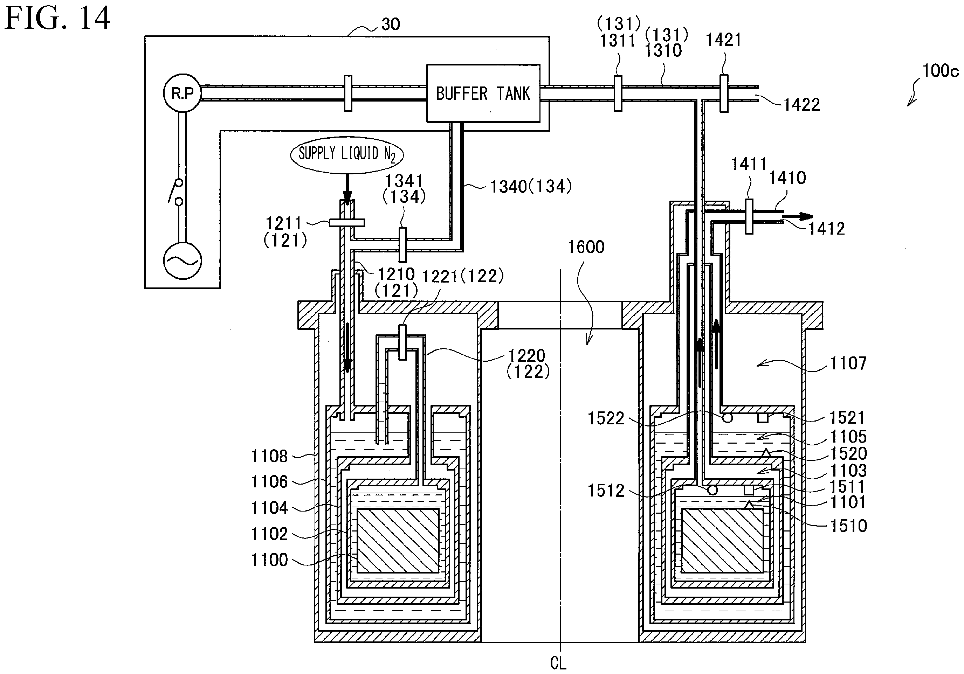

Next, a magnetic-field generating device for NMR 10c according to a fourth embodiment will be described with reference to Fig. 14. Fig. 14 is a schematic view for explaining the magnetic-field generating device for NMR 10c according to the present embodiment. Since the NMR device to which the magnetic-field generating device for NMR 10c according to the present embodiment can be applied, and the oxide superconducting bulk 1100 used in the magnetic-field generating device for NMR 10c are similar to those described in the first embodiment, detailed description thereof is omitted here. In addition, since the magnetization system 1 to which the magnetic-field generating device for NMR according to the present embodiment can be applied is similar to that described in the first embodiment, detailed description is also omitted here.

[4-1. Magnetic-Field Generating Device for NMR 10c]

The magnetic-field generating device for NMR 10c according to the present embodiment includes at least a magnet unit 100c that generates a magnetic field in the bore space 1600, and further includes the control unit 200 as necessary.

In the magnet unit 100c, since the oxide superconducting bulk 1100, the inner tank 1102, the first intermediate tank 1104, the second intermediate tank 1106, and the outer tank 1108, the first cold insulation layer 1101, the first heat insulation layer 1103, the second cold insulation layer 1105, and the second heat insulation layer 1107 are similar to those described in the first embodiment, detailed description thereof is omitted here. The magnet unit 100c further includes the second supply unit (second supply pipe 1210 and second supply valve 1211 provided in second supply pipe 1210) that causes the liquid nitrogen supply device 20, which is externally disposed, to communicate with the second cold insulation layer 1105, the first supply unit (first supply pipe 1220 and first supply valve 1221 provided in first supply pipe 1220) that causes the second cold insulation layer 1105 to communicate with the first cold insulation layer 1101, and the first pressure reducing unit (first pressure reducing pipe 1310 and first pressure reducing valve 1311 provided in first pressure reducing pipe 1310) that causes the first cold insulation layer 1101 to communicate with the pressure reducing device 30, which is externally disposed. Preferably, the magnet unit 100c further includes the second discharge valve 1421. The magnet unit 100c may further include the discharge pipe 1410 that causes the external space of the outer tank 1108 to communicate with the second cold insulation layer 1105, the first discharge valve 1411 provided in the discharge pipe 1410, the first nitrogen amount sensor 1510 that detects the amount of nitrogen in the first cold insulation layer 1101, the first temperature sensor 1511 that detects the temperature of the first cold insulation layer 1101, the second nitrogen amount sensor 1520 that detects the amount of nitrogen in the second cold insulation layer 1105, and the second temperature sensor 1521 that detects the temperature of the second cold insulation layer 1105. Since the second supply pipe 1210, the second supply valve 1211, the first supply pipe 1220, the first supply valve 1221, the first pressure reducing pipe 1310, the first pressure reducing valve 1311, the discharge pipe 1410, the first discharge valve 1411, the second discharge valve 1421, the first nitrogen amount sensor 1510, the first temperature sensor 1511, the second nitrogen amount sensor 1520, and the second temperature sensor 1521 are similar to those described in the first embodiment, detailed description thereof is omitted here.

In the present embodiment, a second pressure reducing unit (second pressure reducing pipe 1340 and second pressure reducing valve 1341 provided in second pressure reducing pipe 1340) that causes the pressure reducing device 30, which is externally disposed, to communicate with the second cold insulation layer 1105 is provided. In Fig. 14, one end of the second pressure reducing pipe 1340 is connected to a buffer tank of the pressure reducing device 30, and the other end of the second pressure reducing pipe 1340 is connected to a portion outside the outer tank 1108. The second pressure reducing pipe 1340 is not limited thereto, and the other end of the second pressure reducing pipe 1340 may be connected to the upper surface of the second intermediate tank 1106. The pressure reducing device 30 may be used as an external pressure reducing device connected to one end of the second pressure reducing pipe 1340, or another pressure reducing device may be used. Here, it is assumed that the pressure reducing device 30 is used in the magnetization system 1.

The second cold insulation layer 1105 is depressurized by the pressure reducing device 30 through the second pressure reducing pipe 1340. As a result, the liquid nitrogen in the second cold insulation layer 1105 is depressurized.

The control unit 200 is similar to the control unit described in the first embodiment, but further has a function of controlling the second pressure reducing valve 1341.

[4-2. Operation of Magnetic-Field Generating Device for NMR 10c]

(4-2-1. Operation During Magnetization)

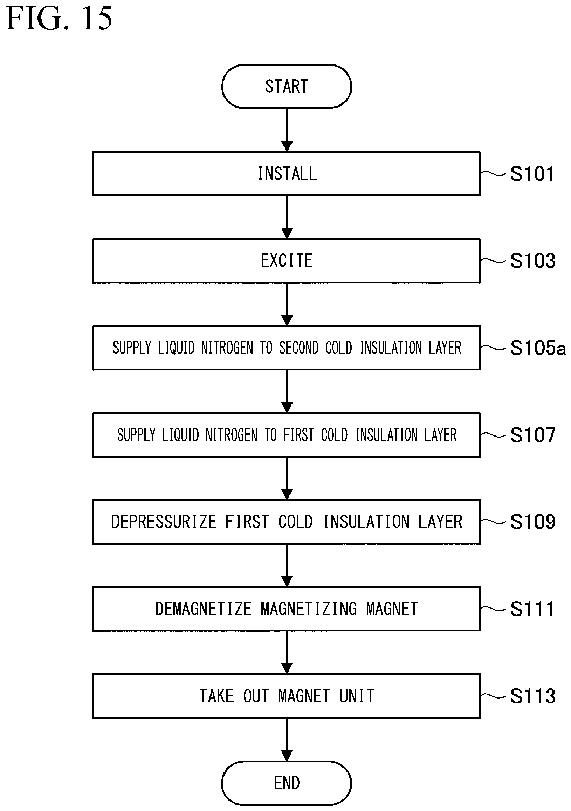

Next, an operation of the magnetic-field generating device for NMR 10c according to the present embodiment will be described with reference to Fig. 15. Fig. 15 is a flowchart for explaining an operation of the magnetic-field generating device for NMR 10c according to the present embodiment when magnetized. Since S101, S103, and S107 to S113 illustrated in Fig. 15 are similar to the operation of the magnetic-field generating device for NMR 10 according to the first embodiment when magnetized, detailed description thereof is omitted here.

In a step (S105a) of supplying liquid nitrogen to the second cold insulation layer 1105, the control unit 200 opens the second supply valve 1211 and the first discharge valve 1411, and closes the first supply valve 1221 and the second pressure reducing valve 1341, so that liquid nitrogen is supplied from the liquid nitrogen supply device 20, which is externally disposed, to the second cold insulation layer 1105 through the second supply pipe 1210. The second supply valve 1211 is controlled based on the amount of liquid nitrogen in the second cold insulation layer 1105, which is detected by the second nitrogen amount sensor 1520 provided on the second cold insulation layer 1105. The second supply valve 1211 may be closed after liquid nitrogen overflows from the first discharge port 1412 to the outside. The nitrogen vaporized from the second cold insulation layer 1105 is exhausted to the outside through the discharge pipe 1410.

(4-2-2. Operation at Time of Replenishing Liquid Nitrogen in NMR Analysis)

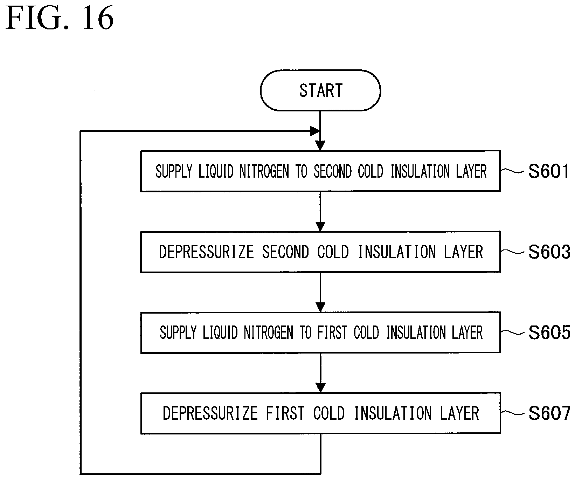

The operation of the magnetic-field generating device for NMR 10c according to the present embodiment when magnetized has been described. Next, an operation of the magnetic-field generating device for NMR 10c at the time of replenishing liquid nitrogen in NMR analysis will be described with reference to Fig. 16. Fig. 16 is a flowchart for explaining an operation of the magnetic-field generating device for NMR 10c according to the present embodiment at the time of replenishing liquid nitrogen. In supplying nitrogen to the depressurized first cold insulation layer, it is excellent in view of the use efficiency of a refrigerant and workability to supply, to the first cold insulation layer, liquid nitrogen that is stored in the second cold insulation layer and functions as a thermal anchor that suppresses heat penetration into the first cold insulation layer, not to directly supply liquid nitrogen from the outside. When liquid nitrogen is directly supplied from an external liquid nitrogen tank, liquid nitrogen temporarily flows in a pipe at room temperature and the pipe with a certain distance needs to be cooled to the liquid nitrogen temperature by a refrigerant, and thus liquid nitrogen is wasted. On the other hand, when liquid nitrogen is supplied from the second cold insulation layer to the first cold insulation layer by using a pipe in a heat-insulated device, liquid nitrogen flows in a short pipe that is already cooled and connects the first cold insulation layer to the second cold insulation layer, so that liquid nitrogen is hardly wasted. In addition, as the pressure difference between the first cold insulation layer and the second cold insulation layer is adjusted by the opening and closing of a valve or the like, liquid nitrogen can be easily supplied to the first cold insulation layer and excellent workability can be achieved. As described above, it can be said that the structure of the present invention is basically excellent in view of the use efficiency of a refrigerant and workability.

The present embodiment is different from the second embodiment in that the second cold insulation layer is used as a precooling chamber, and thus it is unnecessary to have a precooling chamber.

First, when the amount of liquid nitrogen in the second cold insulation layer 1105, which is detected by the second nitrogen amount sensor 1520, is less than a predetermined amount, liquid nitrogen is supplied to the second cold insulation layer 1105 (S601). Specifically, the control unit 200 opens the second supply valve 1211 and the first discharge valve 1411, so that liquid nitrogen is supplied from the liquid nitrogen supply device 20, which is externally disposed, to the second cold insulation layer 1105 through the second supply pipe 1210. The second supply valve 1211 is controlled based on the amount of liquid nitrogen in the second cold insulation layer 1105, which is detected by the second nitrogen amount sensor 1520 provided on the second cold insulation layer 1105. After the amount of liquid nitrogen in the second cold insulation layer 1105 reaches a predetermined amount, the control unit 200 closes the second supply valve 1211. At this time, the second cold insulation layer 1105 has atmospheric pressure.

The second cold insulation layer 1105 is then depressurized (S603). Specifically, the control unit 200 opens the second pressure reducing valve 1341, and closes the second supply valve 1211, the first supply valve 1221, and the first discharge valve 1411, so that the second cold insulation layer 1105 is depressurized to the second pressure that is higher than the first pressure and is lower than 1 atm by the pressure reducing device 30 through the second pressure reducing pipe 1340.

Next, liquid nitrogen is supplied to the first cold insulation layer 1101 (S605). Specifically, the control unit 200 closes the second supply valve 1211, the second pressure reducing valve 1341, and the first discharge valve 1411, and opens the first supply valve 1221, so that liquid nitrogen is supplied from the second cold insulation layer 1105 to the first cold insulation layer 1101 through the first supply pipe 1220. The liquid nitrogen in the second cold insulation layer 1105 is transferred to the first cold insulation layer 1101 by utilizing the pressure difference between the first cold insulation layer 1101 and the second cold insulation layer 1105. The first supply valve 1221 is controlled based on the amount of liquid nitrogen in the first cold insulation layer 1101, which is detected by the first nitrogen amount sensor 1510 provided on the first cold insulation layer 1101.

After that, the control unit 200 depressurizes the first cold insulation layer 1101 to the first pressure (S607). Specifically, since the pressure of the first cold insulation layer 1101 after liquid nitrogen is supplied from the second cold insulation layer 1105 thereto is higher than the first pressure, the control unit 200 opens the first pressure reducing valve 1311 and closes the first supply valve 1221, so that the first cold insulation layer 1101 is depressurized to the first pressure by the pressure reducing device 30 through the first pressure reducing pipe 1310. Further, the control unit 200 checks that the pressure of the second cold insulation layer 1105 is equal to or higher than the atmospheric pressure by using the second pressure sensor 1522, and then opens the first discharge valve 1411. As S601 to S607 described above are repeated, it is possible to maintain a magnetic field that has high intensity and high homogeneity for a long period of time.

According to the magnetic-field generating device for NMR 10c of the present embodiment, cooled liquid nitrogen is present in the second cold insulation layer 1105, so that liquid nitrogen can be supplied to the first cold insulation layer 1101 while the temperature of the first cold insulation layer 1101 is kept at a low temperature without depressurizing the first cold insulation layer 1101 to a pressure equal to or lower than the triple point of nitrogen before liquid nitrogen is supplied to the first cold insulation layer 1101 with a reduced amount of liquid nitrogen. Further, it is possible to omit an operation of replenishing a small amount of liquid nitrogen to the first cold insulation layer 1101 for several times so as to prevent the temperature of the first cold insulation layer 1101 from being equal to or higher than a temperature desired by a user. Moreover, since the temperature of the second cold insulation layer 1105 is kept at a lower temperature, it is possible to suppress heat flowing from the outside of the outer tank 1108 into the oxide superconducting bulk 1100. In supplying nitrogen to the first cold insulation layer 1101 after magnetization is completed, it is desirable to reduce the pressure of the first cold insulation layer 1101 to a third pressure that is lower than the first pressure, and then supply nitrogen.

[Example]

A single crystalline Eu-based oxide superconductor that had a structure in which $Eu_2BaCuO_5$ was dispersed in $EuBa_2Cu_3O_y$, a diameter of about 95 mm, and a thickness of about 35 mm was cut into a ring shape having a diameter of 88.0 mm, an inner diameter of 46.0 mm, and a thickness of 20.0 mm. A reinforcement ring made of aluminum alloy having a thickness of 7.0 mm was fitted into the oxide superconductor, which had been cut out, and these were bonded with a resin. Seven oxide superconductors produced and reinforced in the same manner were stacked to produce an oxide superconducting bulk. The direction of a c-axis, which is the crystal axis of each Eu-based oxide superconductor, was aligned with the axial direction of the ring shape. In addition, the ring-shaped oxide superconductors were also stacked with the ring axes aligned.

The resultant oxide superconducting bulk was housed inside an inner tank having an inner diameter of 42 mm and an outer diameter of 110 mm. A magnet unit each having a hollow ring shape had a structure having the inner tank, a first intermediate tank, a second intermediate tank, and an outer tank. In addition, a first cold insulation layer was arranged around the oxide superconducting bulk inside the inner tank, a first heat insulation layer was arranged between the inner tank and the first intermediate tank, a second cold insulation layer was arranged between the first intermediate tank and the second intermediate tank, and a second heat insulation layer was arranged between the second intermediate tank and the outer tank. The diameter of a bore space in this magnet unit was 20 mm, and the outer diameter of the outer tank was 149 mm at a height corresponding to the center position of a magnetic field of a magnetizing magnet for magnetizing the oxide superconducting bulk. A nitrogen amount sensor was disposed on the first cold insulation layer.

Further, the magnet unit included a second supply pipe causing an external liquid nitrogen supply device to communicate with the second cold insulation layer, a second supply valve in the second supply pipe, a first supply pipe causing the second cold insulation layer to communicate with the first cold insulation layer, a first supply valve in the first supply pipe, a first pressure reducing pipe causing the first cold insulation layer to communicate with an external pressure reducing device, and a first pressure reducing valve in the first pressure reducing pipe. Moreover, a discharge pipe causing the second cold insulation layer to communicate with the external space of the outer tank was provided, and a first discharge valve is provided in the discharge pipe.

This magnet unit and a control unit controlling the second supply valve, the first supply valve, and the first pressure reducing valve constituted a magnetic-field generating device for NMR

A superconducting magnet having a magnetic field homogeneity of 1.0 ppm within a sphere having a radius of 10 mm from the magnetic field center was used as the magnetizing magnet for magnetizing the magnet unit described above. This superconducting magnet had a room temperature bore having a diameter of 150 mm. The magnet unit was arranged in the room temperature bore of the superconducting magnet so that the center position of the oxide superconducting bulk of the magnet unit matched the center of the magnetic field generated by the superconducting magnet. The superconducting magnet was then excited to generate a magnetic field of 5T. Next, liquid nitrogen was supplied to the first cold insulation layer and the second cold insulation layer. The liquid nitrogen in the first cold insulation layer was then cooled to 66K by being depressurized using an external pressure reducing device through the first pressure reducing pipe. The external magnetic field generated by the superconducting magnet was reduced to 0 T at a rate of 0.02 T/min and finally demagnetized, while the liquid nitrogen in the first cold insulation layer was kept at the liquid nitrogen temperature, that is, 66 K by depressurizing the first cold insulation layer by using the pressure reducing device. After demagnetization, the first cold insulation layer was depressurized to 63.2 K.

After the oxide superconducting bulk was magnetized as described above, a cooling system container was taken out of the room temperature bore having a diameter of 150 mm.

After the magnetization described above, the magnetic field distribution on the axis of the bore space in the magnet unit having a diameter of 20 mm was measured, and the ratio of the difference between the maximum magnetic field intensity and the minimum magnetic field intensity to an average magnetic field intensity was calculated. It was found that a magnetic field homogeneity of about 1 ppm was obtained in the region of about 10 mm from the magnetic field center.

Next, when the liquid amount sensor disposed on the first cold insulation layer detected the liquid amount at which the liquid nitrogen in the first cold insulation layer needs to be replenished, the first cold insulation layer was further depressurized, so that a considerable amount of solid nitrogen was present in the first cold insulation layer. After that, the control unit opened the first supply valve to supply liquid nitrogen from the second cold insulation layer to the first cold insulation layer through the first supply pipe at a predetermined supply rate. At this time, the control unit adjusted the first supply valve and the pressure reducing valve with the first discharge valve closed so that the temperature of the first cold insulation layer was equal to or lower than 64K. With these operations, liquid nitrogen could be supplied to the first cold insulation layer while the first cold insulation layer was depressurized to keep the temperature of the first cold insulation layer at 64K or lower. After liquid nitrogen was supplied to the first cold insulation layer, the first cold insulation layer was further depressurized so as to have a temperature of 63.2 K, and an external magnetic field was generated in the bore space by the magnetic-field generating device for NMR The magnetic field distribution on the axis of the bore space having a diameter of 20 mm was measured, and it was found that a magnetic field homogeneity of about 1 ppm was obtained in the region of about 10 mm from the magnetic field center. It could be recognized from the above results that the magnetic-field generating device for NMR was useful.

The preferred embodiments of the present invention have been described above in detail with reference to the accompanying drawings, but the present invention is not limited to these. It is obvious that a person having ordinary knowledge in the technical field to which the present invention pertains can conceive of various modifications or changes within the scope of the technical idea described in the claims, and it is naturally understood that such modifications or changes also belong to the technical scope of the present invention.

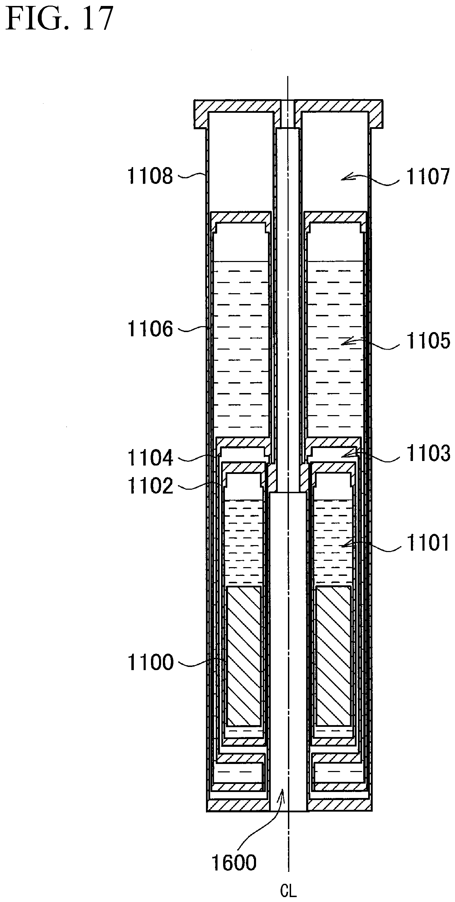

For example, it is preferable that the first intermediate tank 1104 and the second intermediate tank 1106 are not present between the inner peripheral wall of the inner tank 1102 and the inner peripheral wall of the outer tank 1108. Fig. 17 is a schematic view illustrating a modification of the magnet unit according to the present invention. Fig. 17 illustrates the magnet unit 100 based on the actual dimensional ratio. For example, the magnet unit 100 according to the present invention is preferably configured so that, as illustrated in Fig. 14, not the second cold insulation layer 1105 but a heat insulation layer is present between the inner peripheral wall of the inner tank 1102 and the inner peripheral wall of the outer tank 1108. As the magnet unit 100 is configured so that at least the first heat insulation layer 1103 or the second heat insulation layer 1107 is arranged around the first cold insulation layer 1101, the bore space 1600 can be extended while the temperature of the oxide superconducting bulk 1100 is kept low. Further, with the magnet unit 100 having the configuration described above, the oxide superconducting bulk 1100 having a smaller inner diameter can be used.

Further, the magnetic-field generating device for NMR has been described in the above embodiments, but the magnetic-field generating device according to the present invention is not limited to the application for NMR, and for example, can be used for MRI that obtains cross-sectional images of an object from NMR signals or the like, and can also be widely used for devices that utilize MR (magnetic resonance).

[Field of Industrial Application]

According to the present invention, it is possible to provide a magnetic-field generating device and a method for magnetizing the magnetic-field generating device that can more easily obtain a magnetic field with high homogeneity without using liquid helium or a cooling device and further that can suppress cracking of a bulk due to thermal shock.

[Brief Description of the Reference Symbols]

10, 10a, 10b, 10c Magnetic-field generating device for NMR
100, 100a, 100b, 100c Magnet unit
200 Control unit
1100 Oxide superconducting bulk
1101 First cold insulation layer
1102 Inner tank
1103 First heat insulation layer
1104 First intermediate tank
1105 Second cold insulation layer
1106 Second intermediate tank
1107 Second heat insulation layer
1108 Outer tank
121 Second supply unit
1210 Second supply pipe
1211 Second supply valve
122 First supply unit
1220 First supply pipe
1221 First supply valve
1222 Third supply valve
123 Third supply unit
1230 Third supply pipe
1231 Third supply valve
131 First pressure reducing unit
1310 First pressure reducing pipe
1311 First pressure reducing valve
132 Third pressure reducing unit
1320 Third pressure reducing pipe
1321 Third pressure reducing valve
133 Third pressure reducing unit
1330 Third pressure reducing pipe
1331 Third pressure reducing valve
134 Second pressure reducing unit
1340 Second pressure reducing pipe
1341 Second pressure reducing valve
1410 Discharge pipe
1411 First discharge valve
1412 First discharge port
1421 Second discharge valve
1422 Second discharge port
1431 Third discharge valve
1432 Third discharge port
1510 First nitrogen amount sensor
1511 First temperature sensor
1512 First pressure sensor
1520 Second nitrogen amount sensor
1521 Second temperature sensor

1522 Second pressure sensor
1530 Third nitrogen amount sensor
1531 Third temperature sensor
1532 Third pressure sensor
1540 Third nitrogen amount sensor
1541 Third temperature sensor
1542 Third pressure sensor
1600 Bore space
1610 Precooling chamber
1620 Precooling chamber

**Claims**

1. A magnetic-field generating device comprising a magnet unit that generates a magnetic field in a bore space, wherein the magnet unit includes

an inner tank having a hollow ring shape,
a first intermediate tank that is arranged so as to include the inner tank, and
a second intermediate tank that is arranged so as to include the first intermediate tank, and
the magnet unit comprising:

an oxide superconducting bulk that is a ring shape arranged inside the inner tank and has a structure in which single crystalline $ReBa_2Cu_3O_y$ (RE is one, or two or more elements selected from rare earth elements, and $6.8 \leq y \leq 7.1$) is dispersed;
a first cold insulation layer that is arranged around the oxide superconducting bulk inside the inner tank, and is configured to be capable of storing nitrogen at least in a liquid, gas or solid state as a refrigerant, and capable of being depressurized to a first pressure of lower than 1 atm;
a second cold insulation layer that is arranged between the first intermediate tank and the second intermediate tank and is configured to be capable of storing liquid nitrogen as a refrigerant;
a first supply unit configured to be capable of supplying liquid nitrogen to the first cold insulation layer;
a second supply unit configured to be capable of supplying liquid nitrogen to the second cold insulation layer; and
a first pressure reducing unit configured to be capable of depressurizing the first cold insulation layer.

2. The magnetic-field generating device according to claim 1, wherein the first supply unit is configured to allow the second cold insulation layer to communicate with the first cold insulation layer.

3. The magnetic-field generating device according to claim 2, further comprising:

a control unit that controls the magnet unit;
a first nitrogen amount sensor that detects an amount of liquid nitrogen in the first cold insulation layer; and
a second nitrogen amount sensor that detects an amount of liquid nitrogen in the second cold insulation layer, wherein
the control unit controls the first supply unit and the second supply unit based on the amount of liquid nitrogen in the first cold insulation layer and the amount of liquid nitrogen in the second cold insulation layer.

4. The magnetic-field generating device according to any one of claims 1 to 3, wherein the first supply unit further includes a precooling chamber having a third pressure reducing unit configured to be capable of supplying depressurized liquid nitrogen.

5. The magnetic-field generating device according to claim 4, further comprising a control unit that controls the magnet unit, wherein

the precooling chamber further includes

a third supply unit configured to be capable of supplying liquid nitrogen to the precooling chamber and,
a third nitrogen amount sensor that detects an amount of liquid nitrogen in the precooling chamber, and

the control unit controls the first supply unit and the third supply unit so as to allow the amount of liquid nitrogen in the precooling chamber to fall within a predetermined range.

6. The magnetic-field generating device according to claim 4 or 5, further comprising:

   a control unit that controls the magnet unit; and
   a third temperature sensor that detects a temperature of the precooling chamber, wherein
   the control unit controls at least any one of the first supply unit, the third supply unit, or the third pressure reducing unit so as to keep the temperature of the precooling chamber in a predetermined preset temperature range.

7. The magnetic-field generating device according to any one of claims 1 to 6, further comprising a second pressure reducing unit that is capable of depressurizing the second cold insulation layer to a second pressure that is lower than 1 atm and equal to or higher than a first pressure.

8. The magnetic-field generating device according to any one of claims 1 to 7, further comprising:

   a control unit that controls the magnet unit; and
   a first temperature sensor that detects a temperature of the first cold insulation layer, wherein
   the control unit controls at least any one of the first supply unit or the first pressure reducing unit so as to keep the temperature of the first cold insulation layer in a predetermined preset temperature range.

9. A method for magnetizing a magnetic-field generating device according to any one of claims 1 to 8, the method comprising:

   a first step of supplying liquid nitrogen to the second cold insulation layer; and
   a second step of supplying liquid nitrogen to the first cold insulation layer after the first step.

10. The method for magnetizing a magnetic-field generating device according to claim 9, wherein

   the method further comprises, before the first step,
   a third step of arranging the magnet unit in a hollow space of a magnetizing unit having a hollow ring shape; and
   a fourth step of exciting the magnetizing unit to generate an external magnetic field, and
   the method further comprises, after the second step,
   a fifth step of depressurizing the first cold insulation layer to the first pressure; and
   a sixth step of demagnetizing the magnetizing unit to remove the external magnetic field.

11. The method for magnetizing a magnetic-field generating device according to claim 10, further comprising a seventh step of depressurizing the first cold insulation layer to a third pressure lower than the first pressure after the sixth step.

FIG. 1

FIG. 2

FIG. 3

EP 3 798 625 A1

FIG. 4

EP 3 798 625 A1

## FIG. 5

```
                    ┌─────────────┐
                    │    START    │
                    └─────────────┘
                           │
                           ▼
        ┌──────────────────────────────────────┐
        │              INSTALL                  │───S101
        └──────────────────────────────────────┘
                           │
                           ▼
        ┌──────────────────────────────────────┐
        │              EXCITE                   │───S103
        └──────────────────────────────────────┘
                           │
                           ▼
        ┌──────────────────────────────────────────────┐
        │ SUPPLY LIQUID NITROGEN TO SECOND COLD INSULATION LAYER │───S105
        └──────────────────────────────────────────────┘
                           │
                           ▼
        ┌──────────────────────────────────────────────┐
        │ SUPPLY LIQUID NITROGEN TO FIRST COLD INSULATION LAYER │───S107
        └──────────────────────────────────────────────┘
                           │
                           ▼
        ┌──────────────────────────────────────────────┐
        │   DEPRESSURIZE FIRST COLD INSULATION LAYER    │───S109
        └──────────────────────────────────────────────┘
                           │
                           ▼
        ┌──────────────────────────────────────────────┐
        │        DEMAGNETIZE MAGNETIZING MAGNET         │───S111
        └──────────────────────────────────────────────┘
                           │
                           ▼
        ┌──────────────────────────────────────────────┐
        │            TAKE OUT MAGNET UNIT               │───S113
        └──────────────────────────────────────────────┘
                           │
                           ▼
                    ┌─────────────┐
                    │     END     │
                    └─────────────┘
```

# FIG. 6

```
                    ┌─────────────┐
                    │    START    │
                    └──────┬──────┘
   ┌───────────────────────┼
   │   ┌──────────────────────▼─────────────────────────────┐
   │   │ SUPPLY LIQUID NITROGEN TO SECOND COLD INSULATION LAYER │──∽ S201
   │   └────────────────────────┬───────────────────────────┘
   │                            │
   │   ┌────────────────────────▼───────────────────────────┐
   │   │     DEPRESSURIZE FIRST COLD INSULATION LAYER AND      │──∽ S203
   │   │  SUPPLY LIQUID NITROGEN TO FIRST COLD INSULATION LAYER │
   │   └────────────────────────┬───────────────────────────┘
   └────────────────────────────┘
```

FIG. 7

FIG. 8

# FIG. 9

```
          ┌─────────────┐
          │    START    │
          └──────┬──────┘
                 │
                 ▼
   ┌───────────────────────────────┐
   │           INSTALL             │──── S101
   └───────────────┬───────────────┘
                   │
                   ▼
   ┌───────────────────────────────┐
   │            EXCITE             │──── S103
   └───────────────┬───────────────┘
                   │
                   ▼
   ┌───────────────────────────────┐
   │ SUPPLY LIQUID NITROGEN TO      │
   │ SECOND COLD INSULATION LAYER   │──── S105a
   │ AND PRECOOLING CHAMBER         │
   └───────────────┬───────────────┘
                   │
                   ▼
   ┌───────────────────────────────┐
   │ SUPPLY LIQUID NITROGEN TO      │──── S107
   │ FIRST COLD INSULATION LAYER    │
   └───────────────┬───────────────┘
                   │
                   ▼
   ┌───────────────────────────────┐
   │ DEPRESSURIZE FIRST COLD        │──── S109
   │ INSULATION LAYER               │
   └───────────────┬───────────────┘
                   │
                   ▼
   ┌───────────────────────────────┐
   │ DEMAGNETIZE MAGNETIZING MAGNET │──── S111
   └───────────────┬───────────────┘
                   │
                   ▼
   ┌───────────────────────────────┐
   │      TAKE OUT MAGNET UNIT      │──── S113
   └───────────────┬───────────────┘
                   │
                   ▼
          ┌─────────────┐
          │     END     │
          └─────────────┘
```

FIG. 10

```
                    ┌──────────┐
                    │  START   │
                    └────┬─────┘
                         │
    ┌────────────────────▼────────────────────┐
    │  SUPPLY LIQUID NITROGEN TO SECOND COLD INSULATION LAYER  │── S301
    └────────────────────┬────────────────────┘
                         │
    ┌────────────────────▼────────────────────┐
    │      DEPRESSURIZE  PRECOOLING  CHAMBER   │── S303
    └────────────────────┬────────────────────┘
                         │
    ┌────────────────────▼────────────────────┐
    │  SUPPLY LIQUID NITROGEN TO PRECOOLING CHAMBER  │── S305
    └────────────────────┬────────────────────┘
                         │
    ┌────────────────────▼────────────────────┐
    │      DEPRESSURIZE  PRECOOLING  CHAMBER   │── S307
    └────────────────────┬────────────────────┘
                         │
    ┌────────────────────▼────────────────────┐
    │  SUPPLY LIQUID NITROGEN TO FIRST COLD INSULATION LAYER  │── S309
    └────────────────────┬────────────────────┘
                         │
    ┌────────────────────▼────────────────────┐
    │   DEPRESSURIZE  FIRST  COLD  INSULATION LAYER  │── S311
    └─────────────────────────────────────────┘
```

FIG. 11

EP 3 798 625 A1

# FIG. 12

```
                    ┌─────────┐
                    │  START  │
                    └─────────┘
                         │
                         ▼
        ┌───────────────────────────────────────┐
        │              INSTALL                   │── S401
        └───────────────────────────────────────┘
                         │
                         ▼
        ┌───────────────────────────────────────┐
        │              EXCITE                    │── S403
        └───────────────────────────────────────┘
                         │
                         ▼
        ┌───────────────────────────────────────┐
        │ SUPPLY LIQUID NITROGEN TO SECOND COLD  │── S405
        │           INSULATION LAYER             │
        └───────────────────────────────────────┘
                         │
                         ▼
        ┌───────────────────────────────────────┐
        │ SUPPLY LIQUID NITROGEN TO PRECOOLING   │── S407
        │               CHAMBER                  │
        └───────────────────────────────────────┘
                         │
                         ▼
        ┌───────────────────────────────────────┐
        │ SUPPLY LIQUID NITROGEN TO FIRST COLD   │── S409
        │           INSULATION LAYER             │
        └───────────────────────────────────────┘
                         │
                         ▼
        ┌───────────────────────────────────────┐
        │  DEPRESSURIZE FIRST COLD INSULATION    │── S411
        │               LAYER                    │
        └───────────────────────────────────────┘
                         │
                         ▼
        ┌───────────────────────────────────────┐
        │      DEMAGNETIZE MAGNETIZING MAGNET    │── S413
        └───────────────────────────────────────┘
                         │
                         ▼
        ┌───────────────────────────────────────┐
        │         TAKE OUT MAGNET UNIT           │── S415
        └───────────────────────────────────────┘
                         │
                         ▼
                    ┌─────────┐
                    │   END   │
                    └─────────┘
```

# FIG. 13

```
        ┌─────────────┐
        │    START    │
        └─────────────┘
               │
               ▼
┌──────────────────────────────────────────────────┐
│ SUPPLY LIQUID NITROGEN TO SECOND COLD INSULATION LAYER │──── S501
└──────────────────────────────────────────────────┘
               │
               ▼
┌──────────────────────────────────────────────────┐
│   SUPPLY LIQUID NITROGEN TO PRECOOLING CHAMBER    │──── S503
└──────────────────────────────────────────────────┘
               │
               ▼
┌──────────────────────────────────────────────────┐
│          DEPRESSURIZE PRECOOLING CHAMBER          │──── S505
└──────────────────────────────────────────────────┘
               │
               ▼
┌──────────────────────────────────────────────────┐
│ SUPPLY LIQUID NITROGEN TO FIRST COLD INSULATION LAYER │──── S507
└──────────────────────────────────────────────────┘
               │
               ▼
┌──────────────────────────────────────────────────┐
│      DEPRESSURIZE FIRST COLD INSULATION LAYER     │──── S509
└──────────────────────────────────────────────────┘
```

FIG. 14

EP 3 798 625 A1

FIG. 15

```
          ┌─────────────┐
          │    START    │
          └─────────────┘
                 │
                 ▼
   ┌───────────────────────────┐
   │          INSTALL          │──── S101
   └───────────────────────────┘
                 │
                 ▼
   ┌───────────────────────────┐
   │          EXCITE           │──── S103
   └───────────────────────────┘
                 │
                 ▼
   ┌───────────────────────────────────────────┐
   │ SUPPLY LIQUID NITROGEN TO SECOND COLD INSULATION LAYER │──── S105a
   └───────────────────────────────────────────┘
                 │
                 ▼
   ┌───────────────────────────────────────────┐
   │ SUPPLY LIQUID NITROGEN TO FIRST COLD INSULATION LAYER │──── S107
   └───────────────────────────────────────────┘
                 │
                 ▼
   ┌───────────────────────────────────────┐
   │ DEPRESSURIZE FIRST COLD INSULATION LAYER │──── S109
   └───────────────────────────────────────┘
                 │
                 ▼
   ┌───────────────────────────────────┐
   │   DEMAGNETIZE MAGNETIZING MAGNET   │──── S111
   └───────────────────────────────────┘
                 │
                 ▼
   ┌───────────────────────────────────┐
   │      TAKE OUT MAGNET UNIT          │──── S113
   └───────────────────────────────────┘
                 │
                 ▼
          ┌─────────────┐
          │     END     │
          └─────────────┘
```

## FIG. 16

```
┌──────────┐
│  START   │
└──────────┘
     │
     ▼
┌────────────────────────────────────────────────────┐
│ SUPPLY LIQUID NITROGEN TO SECOND COLD INSULATION LAYER │──S601
└────────────────────────────────────────────────────┘
     │
     ▼
┌────────────────────────────────────────────────────┐
│    DEPRESSURIZE SECOND COLD INSULATION LAYER        │──S603
└────────────────────────────────────────────────────┘
     │
     ▼
┌────────────────────────────────────────────────────┐
│ SUPPLY LIQUID NITROGEN TO FIRST COLD INSULATION LAYER │──S605
└────────────────────────────────────────────────────┘
     │
     ▼
┌────────────────────────────────────────────────────┐
│    DEPRESSURIZE FIRST COLD INSULATION LAYER         │──S607
└────────────────────────────────────────────────────┘
```

# FIG. 17

**EP 3 798 625 A1**

## INTERNATIONAL SEARCH REPORT

| | International application No. |
|---|---|
| | PCT/JP2019/020564 |

**A. CLASSIFICATION OF SUBJECT MATTER**
Int.Cl. G01N24/00(2006.01)i, H01F6/04(2006.01)i

According to International Patent Classification (IPC) or to both national classification and IPC

**B. FIELDS SEARCHED**

Minimum documentation searched (classification system followed by classification symbols)
Int.Cl. G01N24/00-24/14, G01R33/20-33/64, H01F6/04, F25D3/10

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2006-54444 A (BRUKER BIOSPIN AG) 23 February 2006, paragraphs [0022]-[0032]<br>& US 2007/0051115 A1, paragraphs [0027]-[0036] & EP 1617157 A2 | 1, 4, 6, 8<br>2-3, 5, 7, 9-11 |
| Y<br>A | WO 92/22077 A1 (NIPPON STEEL CORPORATION) 10 December 1992, page 4, line 5 to page 7, line 29<br>& US 5477693 A, column 3, line 22 to column 6, line 43 & WO 1992/022077 A1 & EP 541819 A1 | 1, 4, 6, 8<br>2-3, 5, 7, 9-11 |

☒ Further documents are listed in the continuation of Box C.　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01.07.2019 | 16.07.2019 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

46

**INTERNATIONAL SEARCH REPORT**

| International application No. |
| --- |
| PCT/JP2019/020564 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2006-52921 A (MAYEKAWA MFG CO., LTD.) 23 February 2006, paragraph [0024] (Family: none) | 6, 8 |
| A | US 2015/0332830 A1 (JIANG et al.) 19 November 2015 & JP 2006-326294 A & GB 2427669 A | 1-11 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018098955 A
- JP 2002006021 A
- JP S63165812 B
- WO 9222077 A
- JP 5086920 B